# EUROPEAN PATENT APPLICATION

(11) **EP 3 961 726 A1**
(43) Date of publication of application: **02.03.2022**
(21) Application number: 20936081.7
(22) Date of filing: 18.11.2020
(51) Int. Cl.: H01L 31/05, H01L 31/0224, H01L 31/18

(54) **BACK-CONTACT SOLAR CELL MODULE AND PREPARATION METHOD**

(30) Priority: 21.05.2020 CN 202010436135; 10.06.2020 CN 202010522953
(71) Applicant: Jingao Solar Co., Ltd., Xingtai, Hebei 055550 (CN)
(72) Inventor: JIANG, Xiulin, Yangzhou, Jiangsu 225131 (CN); TANG, Wenshuai, Yangzhou, Jiangsu 225131 (CN); TANG, Kun, Yangzhou, Jiangsu 225131 (CN); WU, Lanfeng, Yangzhou, Jiangsu 225131 (CN)
(74) Representative: Sun, Yiming
(86) International application number: PCT/CN2020/129783
(87) International publication number: WO 2021/232715

(57) **Abstract**

The invention, which discloses a back contact type solar cell module and a preparation method, relates to the technical field of solar cells. The back contact type solar cell module may comprise: N small cell pieces, p+ doped regions and n+ doped regions arranged in a staggered manner being provided on the back surface of the small cell piece, the p+ doped regions of the small cell piece being provided with positive electrode fine grid lines, the n+ doped regions of the small cell piece being provided with negative electrode fine grid lines, and each of the small cell pieces being not provided with a main grid line for collecting currents of the n+ doped regions and the p+ doped regions; (N-1) conductive strips, each of which includes a substrate and conductive patterns provided on the substrate, each of the substrates being provided between two adjacent small cell pieces, and the conductive patterns being used for electrically connecting fine grid lines with opposite polarities on two adjacent small cell pieces at intervals in sequence so as to connect the respective small cell pieces in series. The back contact type solar cell module provided in the implementation mode has a comparatively high efficiency stability, and a low resistance loss on silver grid lines, and the fill factor of the module is high.

## Description

The present application claims the priority of the Chinese Patent Application No. 202010436135.8, entitled "Back Contact Type Solar Cell Module and Preparation Method Thereof", which was filed on May 21, 2020, and the priority of the Chinese Patent Application No. 202010522953.X, entitled "Solar Cell Module and Preparation Method", which was filed on June 10, 2020, the disclosures of which are fully recited herein as a part of the present application.

### Technical Field

The invention relates to the technical field of solar cells, and in particular relates to a back contact type solar cell module and a preparation method.

### Background Art

The pursuit of a lower production cost and a higher photoelectric conversion efficiency in the technical field of solar cells is the core of the solar cell industry. A full-back contact type solar cell differs from a conventional solar cell in that both positive and negative electrodes thereof are placed on the back surface of the cell, thereby avoiding similar optical losses on the front surface of the conventional solar cell and improving the photoelectric conversion efficiency of the cell, so it is one of cell types having been widely concerned and studied in the technical field of high-efficiency cells.

The existing full-back contact type solar cells all have main grid designs, and the main grid has both of the functions of collecting currents and connecting welding belts. Since the full-back contact type solar cell has comparatively high short-circuit currents, the full-back contact type solar cell has to adopt more main grid designs to reduce a power loss caused by line resistances on main grid lines and fine grid lines, which will consume more silver pastes than the conventional solar cell. At the same time, since elongated n+ doped regions and p+ doped regions arranged in parallel and the fine grid lines respectively connected thereto are arranged at intervals, it is further required to consider how to avoid a problem of a cell failure due to a short circuit of the positive and negative electrodes of the cell during the design of the main grid of the cell.

At present, one solution is to introduce additional insulating materials and process steps to achieve that the main grids of the positive and negative electrodes are only connected to the fine grid lines with consistent polarities, which method, however, has a complicated process, a high cell manufacturing cost, and low stabilities of cell efficiency and module power, and has module power decrease and even electrical safety problems during power generation in the next few decades. Another solution is to design the positive and negative electrodes in a shape of the character " 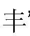 ", the fine grid line of the negative electrode avoids the main grid line of the positive electrode, and the fine grid line of the positive electrode avoids the main grid line of the negative electrode. In this way, there are no staggered places on the two-dimensional patterns of the positive and negative electrodes, whereby the problem of reverse leakage is solved. However, for such design, due to a long lateral transmission distance of carriers, the carriers are difficult to be collected by the fine grid lines with positive and negative polarities, so the series resistance of the cell will rise sharply, and the fill factor and photoelectric conversion efficiency of the cell will be greatly affected.

In addition, in the process of fabricating the traditional full-back contact type solar cell module with main grids designed on the front surface, the cell module further has a problem of cracks or fragments caused by uneven warping of the silicon wafer due to use of a large number of welding belts, or a problem of increase of the difficulty of precision control and the fabricating cost due to use of an integrally molded back plate design. Thus, how to simplify the fabricating process of the full-back contact type solar cell module and mass-produce full-back contact type solar cell modules with stable performances that are accepted by markets is an urgent problem to be solved.

### Summary of the Invention

In view of this, the invention provides a back contact type solar cell module and a preparation method thereof. The preparing method can greatly simplify the manufacturing process of the back contact type solar cell module, reduce the manufacturing cost of the cell, and avoid the occurrence of cracks or fragments in cell pieces; the back contact type solar cell module prepared by this method has a comparatively high efficiency stability, and a low resistance loss on silver grid lines, and the fill factor of the module is high.

In order to achieve the aforesaid objects, according to one aspect of the embodiment of the invention, a back contact type solar cell module is provided, the back contact type solar cell module comprising:
N small cell pieces, p+ doped regions and n+ doped regions arranged in a staggered manner being provided on the back surface of the small cell piece, the p+ doped regions of the small cell piece being provided with positive electrode fine grid lines, the n+ doped regions of the small cell piece being provided with negative electrode fine grid lines, and each of the small cell pieces being not provided with a main grid line for collecting currents of the n+ doped regions and the p+ doped regions;
(N-1) conductive strips, each of which includes a substrate and conductive patterns provided on the substrate, each of the substrates being provided between two adjacent small cell pieces, and the conductive patterns being used for electrically connecting fine grid lines with opposite polarities on two adjacent small cell pieces at intervals in sequence so as to connect the respective small cell pieces in series.

Preferably, the n+ doped regions and the p+ doped regions on two adjacent ones of the small cell pieces are arranged in one-to-one correspondence, and the conductive pattern is formed by several conductive fold lines arranged in rows, and the conductive fold lines are stepped.

Preferably, the n+ doped regions and the p+ doped regions on two adjacent ones of the small cell pieces are arranged in a staggered and corresponding manner, and the conductive pattern of the conductive strip is formed by several straight lines arranged in rows.

Preferably, the conductive pattern includes a plurality of sections of conductive adhesive or a plurality of sections of solder.

Preferably, each section of the conductive adhesive or each section of the solder is connected to one of the positive electrode contact fine grids of one of the small cell pieces and one of the negative electrode contact fine grids of the other adjacent one of the small cell pieces.

Preferably, the small cell pieces are formed by cutting a back contact type solar cell piece.

Preferably, the (N-1) conductive strips are located on a same back plate, and each of the substrates is a partial region of the back plate.

Preferably, the structures of the two adjacent side surfaces of the adjacent p+ doped region and n+ doped region are complementary.

Preferably, the structures of the p+ doped region and the n+ doped region are any one of a rectangular structure, a trapezoidal shape, a sawtooth shape, and a square wave shape.

Preferably, the n+ doped region is strip-shaped, including wide rectangular strips and narrow rectangular strips arranged in a staggered manner; the p+ doped region is filled between two adjacent n+ doped regions.

Preferably, the relationship between the N small cell pieces includes: a combination of relationships that doped regions of the same type are arranged oppositely in two adjacent small cell pieces, and doped regions of opposite types are arranged oppositely in two adjacent small cell pieces.

Preferably, the substrate has an expansion coefficient close to that of silicon.

Preferably, the substrate is a conductive silicon wafer.

According to a second aspect, the embodiment of the invention provides a back contact type solar cell module, comprising: a plurality of small back contact type solar cell pieces, and a back plate provided with at least one section of conductive adhesive, wherein:
the small back contact type solar cell piece includes: a silicon substrate, p+ doped regions and n+ doped regions alternately arranged on the back surface of the silicon substrate, positive electrode fine grid lines arranged on the p+ doped regions, and negative electrode fine grid lines arranged on the n+ doped regions;
the plurality of small back contact type solar cell pieces are arranged side by side, wherein the side surfaces of every two adjacent ones of the small back contact type solar cell pieces are opposite;
in the two opposite sides of two adjacent ones of the small back contact type solar cell pieces, a positive electrode contact fine grid end on one of the two opposite sides is electrically isolated from the side, and a negative electrode contact fine grid end on the other of the two opposite sides is electrically isolated from the other side;
each section of the conductive adhesive is distributed between two adjacent ones of the small back contact type solar cell pieces;
each section of the conductive adhesive is connected to the negative electrode contact fine grid of one of the small back contact type solar cell pieces and the positive electrode contact fine grid of the other adjacent one of the small back contact type solar cell pieces.

Preferably, the positive electrode contact fine grid end on one of the two opposite sides is covered by an insulating layer, and the negative electrode contact fine grid end on the other of the two opposite sides is covered by an insulating layer.

Preferably, the positive electrode contact fine grid end on one of the two opposite sides is a shortened end relative to the side, and
the negative electrode contact fine grid end on the other of the two opposite sides is a shortened end relative to the other side.

Preferably, the conductive adhesive has an elongated structure;
the positive electrode contact fine grid end on one of the two opposite sides is connected to one long side of the elongated structure;
the negative electrode contact fine grid end on the other of the two opposite sides is connected to the other long side of the elongated structure.

Preferably, the conductive adhesive includes: an elongated main body and a plurality of branch sections connected to the elongated main body that are separately arranged on both sides of the elongated main body, wherein each branch section on one side of the elongated main body and one positive electrode contact fine grid of one of the adjacent small back contact type solar cell pieces, and each branch section on the other side of the elongated main body and one negative electrode contact fine grid of the other of the adjacent small back contact type solar cell pieces.

Preferably, the back contact type solar cell module further comprises: a first encapsulation layer;
the first encapsulation layer is used for filling a gap between the small cell piece and the back plate.

Preferably, the back contact type solar cell module further comprises: a glass plate and a second encapsulation layer, wherein:
the glass plate is opposite to the plurality of small back contact type solar cell pieces;
the second encapsulation layer is arranged between the glass plate and the plurality of small back contact type solar cell pieces;
the first encapsulation layer and the second encapsulation layer are used for encapsulating the plurality of small back contact type solar cell pieces between the glass plate and the back plate.

According to a third aspect, the embodiment of the invention provides a method for preparing a back contact type solar cell module, comprising the following steps:
S1: cutting a small back contact type solar cell piece at equal intervals along the short sides of the n+ doped regions or the p+ doped regions to obtain several small cell pieces;
S2: arranging conductive patterns on a substrate to form a conductive strip, and sequentially connecting the respective small cell pieces in series by the conductive strips to form a cell string;
S3: sequentially subjecting the cell string to confluence, stacking and lamination for encapsulation to obtain the back contact type solar cell module.

Preferably, in S1, 2≦N≦20.

Preferably, in S2, the conductive pattern is dried for solidification on the substrate by printing with a solder or a conductive adhesive, the temperature of drying for solidification is 100-500°C, and the time thereof is 30-600 s.

Preferably, the solder is tin, a tin-lead alloy, a tin-bismuth alloy or a tin-lead-silver alloy; the conductive adhesive is an adhesive wrapped with conductive particles, the adhesive is one or more of epoxy resin, phenolic resin, polyurethane, thermoplastic resin or polyimide, and the conductive particles are silver, gold or copper, or alloy particles composed of two or more of silver, gold or copper.

According to a fourth aspect, the embodiment of the invention provides a method for preparing a back contact type solar cell module, comprising:
a step of preparing a back contact type solar cell piece;
printing a conductive adhesive on one surface of a back plate;
arranging a plurality of small back contact type solar cell pieces on the back plate, connecting the plurality of small back contact type solar cell pieces in series by the conductive adhesive, and performing drying for solidification.

The aforesaid one embodiment in the invention has the following advantages or beneficial effects: first, the back contact type solar cell module provided by the invention completely abandons the conventional design of the main grid line, which greatly simplifies the cell manufacturing process, improves the efficiency stability of the cell, and reduces the cell manufacturing cost;
second, the invention uses conductive strips to connect the respective small cell pieces in series, wherein the conductive strip is composed of a substrate and conductive patterns, the substrate is a carrier plate, and the conductive patterns are used to electrically connect fine grid lines with opposite polarities on two adjacent small cell pieces, so when the small cell pieces are connected in series, it is only required to electrically connect the conductive patterns to the fine grid lines with opposite polarities on the two small cell pieces at intervals in sequence, so that the current on the cell string is led out along the electrically connected doped regions by the conductive patterns. In this way, when the small cell pieces are produced, there is no longer limitation by the design of the main grid line for collecting current regions (e.g., although the positive electrode fine grids and the negative electrode fine grids are arranged parallel to each other and alternately, the two ends of the positive electrode fine grid and the two ends of the negative electrode fine grid are required to be not aligned, i.e., one end of the positive electrode fine grid has a protruding end relative to one end of the negative electrode fine grid, and the other end of the positive electrode fine grid has a shortened end relative to the other end of the negative electrode fine grid, etc.). The elongated n+ doped regions and p+ doped regions in the present application can directly penetrate the whole cell piece during production, and then the cell piece is directly cut into a plurality of small cell pieces along the short sides of the n+ doped regions or the p+ doped regions, which small cell pieces are then connected to each other by conductive sheets printed with particular conductive patterns to form a cell string. As compared with the prior art, the invention simplifies the cell manufacturing process, increases the production capacity, and reduces the manufacturing cost of the cell.

In addition, the invention is composed of several small cell pieces connected in series. As compared with a whole back contact type solar cell piece, the invention reduces the current of each string composed of cell pieces, and reduces the influence of the resistance loss on silver grid lines, thereby improving the fill factor of the module;
in addition, the whole back contact type solar cell module has no design of welding belts except for the confluence region of the cell string, which greatly reduces the cost of the module; moreover, as repeatedly tested and verified by the inventor, the current of the module is subjected to the smallest resistance with the transmission path as shown in the invention during the transmission between adjacent small back contact type solar cell pieces, which reduces the influence of the resistance loss on silver grid lines, thereby improving the fill factor of the module.

In addition, the substrate of the conductive strips of the invention has an expansion coefficient close to that of silicon, or the substrate can be still a silicon wafer consistent with the substrate of the cell piece, thereby avoiding the occurrence of cracks or fragments caused by inconsistency of the thermal expansion coefficients of the two parts.

In addition, since the conductive adhesive can shorten the distance between a plurality of small back contact type solar cell pieces connected in series, and the conductive adhesive as well as the positive electrode contact fine grids and the negative electrode contact fine grids can eliminate the lateral transmission loss and electrode shielding effect brought by the main grid, and in addition, since the plurality of sections of conductive adhesive are distributed between every two adjacent small back contact type solar cell pieces, and meanwhile one section of conductive adhesive is connected to one positive electrode contact fine grid of one of the small back contact type solar cell pieces and one negative electrode contact fine grid of the other adjacent one of the small back contact type solar cell pieces, the series circuits formed by the plurality of small back contact type solar cell pieces and the plurality of sections of conductive adhesive are relatively independent, that is, the positive electrode contact fine grids and the negative electrode contact fine grids are connected in series in a one-to-one manner, so that the current transmission paths are fixed and independent of each other, which can effectively reduce the interference of adjacent series circuits, avoid current dispersion and diffusion, and effectively reduce the current loss, thereby further improving the fill factor, and the stabilities of the photoelectric conversion efficiency and the photoelectric conversion efficiency of the full-back contact type solar cell module.

Further effects of the aforesaid non-conventional optional manners will be described below in combination with specific implementation modes.

### Brief Description of the Drawings

Figures are used to better understand the invention, and do not form improper limitations of the invention. Where:
FIG. 1 is a cross-sectional view of a full-back contact type solar cell piece provided according to Embodiments 1-2 of the invention;
FIG. 2 is a bottom view according to FIG. 1;
FIG. 3 shows small cell pieces arranged after the cutting of the full-back contact type solar cell piece according to Embodiment 1;
FIG. 4 is a schematic diagram of a structure of a conductive strip provided according to an embodiment of the invention;
FIG. 5 shows a full-back contact type solar cell string provided according to Embodiment 1 of the invention;
FIG. 6 shows small cell pieces arranged after the cutting of the full-back contact type solar cell piece according to Embodiment 2;
FIG. 7 is a schematic diagram of a structure of a conductive strip provided according to another embodiment of the invention;
FIG. 8 shows a full-back contact type solar cell string provided according to Embodiment 2 of the invention;
FIG. 9 is a schematic diagram of a structure of a full-back contact type solar cell piece provided according to Embodiments 3-4 of the invention;
FIG. 10 shows small cell pieces arranged after the cutting of the full-back contact type solar cell piece according to Embodiment 3;
FIG. 11 shows a full-back contact type solar cell string provided according to Embodiment 3 of the invention;
FIG. 12 shows small cell pieces arranged after the cutting of the full-back contact type solar cell piece according to Embodiment 4;
FIG. 13 shows a full-back contact type solar cell string provided according to Embodiment 4 of the invention;
FIG. 14 is a schematic diagram of a structure where conductive strips are located on a same back plate according to an embodiment of the invention;
FIG. 15 is a schematic diagram of a structure where conductive strips are located on a same back plate according to another embodiment of the invention;
FIG. 16 is a schematic diagram of a structure of a full-back contact type solar cell string formed by connecting conductive strips located on a same back plate in series provided according to an embodiment of the invention;
FIG. 17 is a schematic diagram of a structure of a full-back contact type solar cell string formed by connecting conductive strips located on a same back plate in series provided according to another embodiment of the invention;
FIG. 18 is a schematic diagram of a structure of a full-back contact type solar cell string formed by connecting conductive strips located on a same back plate in series provided according to a further embodiment of the invention;
FIG. 19 is a schematic diagram of a structure of a full-back contact type solar cell string formed by connecting conductive strips located on a same back plate in series provided according to another embodiment of the invention;
FIG. 20 is a schematic diagram of a structure of a full-back contact type solar cell string formed by connecting conductive strips located on a same back plate in series provided according to a further embodiment of the invention;
FIG. 21 is a schematic diagram of a structure of a full-back contact type solar cell string formed by connecting conductive strips located on a same back plate in series provided according to another embodiment of the invention;
FIG. 22 is a schematic diagram of a structure of a conductive adhesive provided according to an embodiment of the invention;
FIG. 23 is a schematic diagram of a structure of a conductive adhesive provided according to another embodiment of the invention;
FIG. 24 is a schematic diagram of a structure of a full-back contact type solar cell string formed by connecting conductive strips located on a same back plate in series provided according to a further embodiment of the invention;
FIG. 25 is a schematic diagram of a structure of a full-back contact type solar cell string formed by connecting conductive strips located on a same back plate in series provided according to another embodiment of the invention;
FIG. 26 is a schematic diagram of a structure of a full-back contact type solar cell string formed by connecting conductive strips located on a same back plate in series provided according to a further embodiment of the invention;
FIG. 27 is a schematic diagram of a structure of a full-back contact type solar cell string formed by connecting conductive strips located on a same back plate in series provided according to another embodiment of the invention;
FIG. 28 is a schematic diagram of a structure of a full-back contact type solar cell string formed by connecting conductive strips located on a same back plate in series provided according to a further embodiment of the invention;
FIG. 29 is a schematic diagram of a relative relationship between two adjacent small back contact type solar cell pieces according to an embodiment of the invention;
FIG. 30 is a schematic diagram of a relative relationship between two adjacent small back contact type solar cell pieces according to a further embodiment of the invention;
FIG. 31 is a schematic diagram of a relative relationship between two adjacent small back contact type solar cell pieces according to another embodiment of the invention;
FIG. 32 is a schematic diagram of a relative relationship between two adjacent small back contact type solar cell pieces according to a further embodiment of the invention;
FIG. 33 is a schematic diagram of a structure of a full-back contact type solar cell string formed by connecting conductive strips located on a same back plate in series provided according to a further embodiment of the invention;
FIG. 34 is a schematic diagram of a structure of a conductive adhesive provided on a back plate according to another embodiment of the invention;
FIG. 35 is a schematic diagram of a structure of a full-back contact type solar cell string formed by connecting conductive strips located on a same back plate in series provided according to a further embodiment of the invention;
FIG. 36 is a schematic diagram of a structure of a back contact type solar cell module according to a further embodiment of the invention;
FIG. 37 is a schematic diagram of a main flow of a method for preparing a solar cell module according to an embodiment of the invention; and
FIG. 38 is a schematic diagram of a back contact type solar cell piece according to another embodiment of the invention.

**Descriptions of reference signs:**

| | | | |
|---|---|---|---|
| 1 | silicon substrate; | | |
| 2 | p+ doped region; | | |
| 21 | positive electrode; | 21' | shortened end of a positive electrode contact fine grid |
| 3 | n+ doped region; | | |
| 31 | negative electrode; | 31' | shortened end of a negative electrode contact fine grid |
| 4 | n+ front surface field (FSF) with a low surface doping concentration; | | |
| 5 | anti-reflection laminated passivation film; | | |
| 6 | reflection-enhancing laminated passivation film; | | |
| 7 | conductive strip; 70 back plate; | | |
| 71 | substrate; 72 conductive pattern; | | |
| 721 | one long side of a conductive adhesive having an elongated structure; | | |
| 722 | the other long side of the conductive adhesive having an elongated structure; | | |
| 723 | main body having an elongated structure; | | |
| 724 | branch section | | |
| 8 | insulating layer | | |
| 9 | glass plate; | | |
| 10 | encapsulation layer (first encapsulation layer or second encapsulation layer). | | |

### Detailed Description

The technical solution of the invention will be described below in combination with the figures.

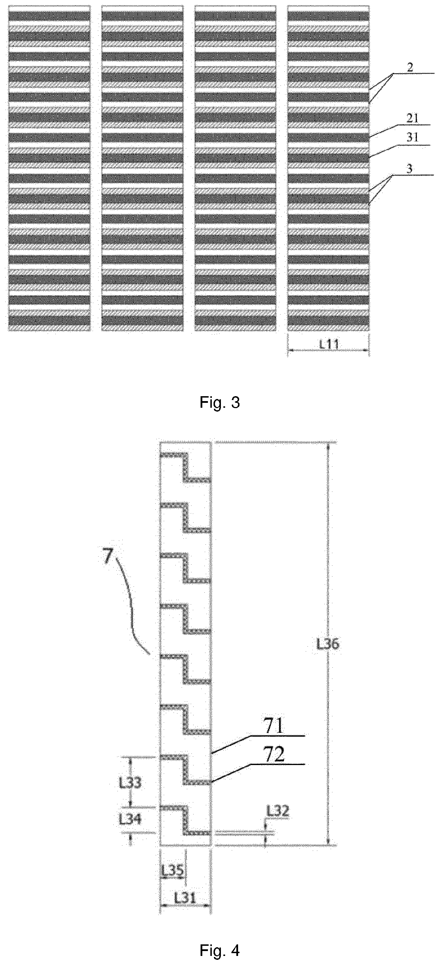

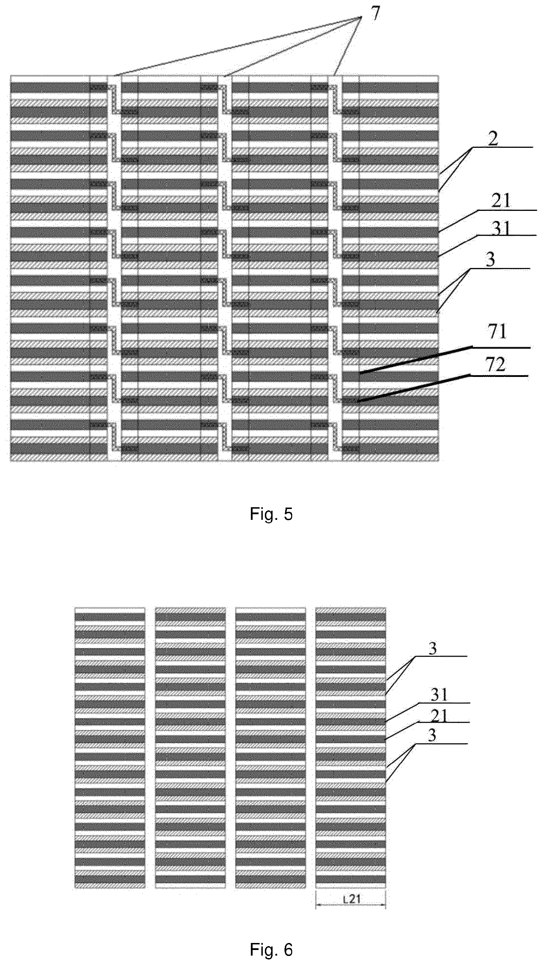

Please refer to FIG. 3, which shows small cell pieces arranged after the cutting of the full-back contact type solar cell piece. The invention provides a back contact type solar cell module, which comprises several small cell pieces and conductive strips 7, wherein p+ doped regions 2 and n+ doped regions 3 arranged in a staggered manner are laid on the back surface of each small cell piece along its length, the p+ doped regions 2 are printed with positive electrode fine grid lines (positive electrodes 21) in contact therewith, the n+ doped regions 3 are printed with negative electrode fine grid lines (negative electrodes 31) in contact therewith, and the lengths of the positive electrode fine grid lines (positive electrodes 21) and the negative electrode fine grid lines (negative electrodes 31) are infinitely close to the width of the small cell piece. Please refer to FIG. 4, where the conductive strip 7 includes a substrate 71 and conductive patterns 72 provided on the substrate 71. Please refer to FIG. 5, where the substrate 71 is provided between two adjacent small cell pieces, and the conductive patterns 72 are used for electrically connecting fine grid lines with opposite polarities on two adjacent small cell pieces at intervals in sequence so as to connect the respective small cell pieces in series, which may be specifically as follows: electrically connecting all the positive electrode fine grid lines (positive electrodes 21) that are relatively located on the left small cell piece to all the negative electrode fine grid lines (negative electrodes 31) provided on the adjacent small cell piece, or electrically connecting all the negative electrode fine grid lines (negative electrodes 31) that are relatively located on the right small cell piece to all the positive electrode fine grid lines (positive electrodes 21) provided on the adjacent small cell piece, and the respective small cell pieces being connected in series by the conductive strips 7.

As compared with the prior art, first, the back contact type solar cell module provided by the invention completely abandons the conventional design of the main grid line, which greatly simplifies the cell manufacturing process, improves the efficiency stability of the cell, and reduces the cell manufacturing cost; second, there is no longer limitation by the design of the main grid line for collecting current regions, the elongated n+ doped regions 3 and p+ doped regions 2 can penetrate the whole cell piece, which also simplifies the cell manufacturing process, increases the production capacity, and reduces the manufacturing cost of the cell; further, the back contact type solar cell module provided by the invention is composed of several small cell pieces, which are formed by cutting a whole back contact type solar cell piece, connected in series, which reduces the current of each string composed of cell pieces, and reduces the influence of the resistance loss on silver grid lines, thereby improving the fill factor of the module; finally, the whole back contact type solar cell module has no design of welding belts except for the confluence region of the cell string, which greatly reduces the cost of the module; moreover, as repeatedly tested and verified by the inventor, the current of the module is subjected to the smallest resistance with the transmission path as shown in the invention during the transmission between adjacent small back contact type solar cell pieces, which reduces the influence of the resistance loss on silver grid lines, thereby improving the fill factor of the module.

In order to avoid cracks or fragments caused by inconsistency of the thermal expansion coefficients of the substrate 71 in the conductive strip 7 and the silicon substrate 1 of the cell piece, in this embodiment, the expansion coefficient of the substrate 71 of the conductive strip 7 is set to one close to that of silicon, and the substrate 71 can be certainly a conductive silicon wafer, which has better have a coating, consistent with the silicon substrate 1 of the cell piece, or a conductive silicon wafer with a high resistivity is selected, which can effectively reduce an electrical contact between the conductive silicon wafer and the cell piece. The conductive pattern 72 is formed by a solder or a conductive adhesive, and the solder can be tin, a tin-lead alloy, a tin-bismuth alloy or a tin-lead-silver alloy; the conductive adhesive is specifically an adhesive wrapped with conductive particles, the adhesive may be one or more of epoxy resin, phenolic resin, polyurethane, thermoplastic resin or polyimide, and the conductive particles may be silver, gold or copper, or alloy particles composed of two or more of silver, gold or copper.

In this embodiment, the n+ doped regions 3 and the p+ doped regions 2 of the back contact type solar cell module are rectangular strips of equal widths, and the n+ doped regions 3 and the p+ doped regions 2 on two adjacent small cell pieces are arranged in one-to-one correspondence, the conductive pattern 72 of the conductive strip 7 is composed of several conductive fold lines arranged in rows along the lengths of the rectangular strips, and the conductive fold lines are stepped.

That the n+ doped regions 3 and the p+ doped regions 2 on two adjacent small cell pieces are arranged in one-to-one correspondence specifically refers to, as shown in FIG. 3, that the n+ doped regions 3 of one of the two adjacent small cell pieces and the n+ doped regions 3 of the other small cell piece are in one-to-one correspondence, and the p+ doped regions 2 of one of the two adjacent small cell pieces and the p+ doped regions 2 of the other small cell piece are in one-to-one correspondence.

### Embodiment 1

A method for preparing a back contact type solar cell module according to the embodiment comprises the following steps:

### (1) Preparation of a back contact type solar cell piece

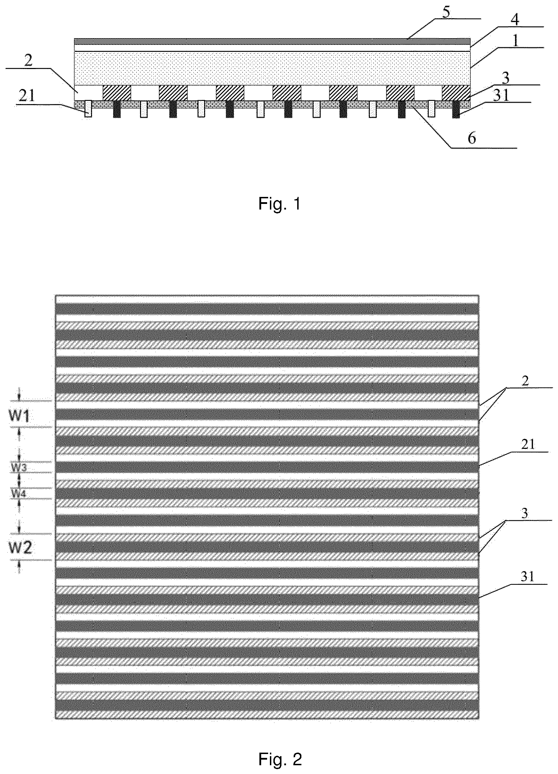

Please refer to FIG. 1, where an n-type single crystal silicon substrate 1, which has a resistivity of 1-30 Ω•cm, a thickness of 50-300 µm, and a length of 156.75 mm, is selected. The n-type single crystal silicon substrate 1 is subjected to surface texturing treatment before being used, then the p+ doped regions 2 and the n+ doped regions 3 alternately arranged are fabricated on the back surface of the n-type single crystal silicon substrate 1 by a combination of techniques such as diffusion, laser drilling, ion implantation and annealing, masking, and etching, and an n+ front surface field (FSF)4 with a low surface doping concentration is fabricated on the front surface of the n-type single crystal silicon substrate 1. Please refer to FIG. 2, where the p+ doped region 2 has a length of 156.75 mm the same as that of the n-type single crystal silicon substrate 1, and has a width W1=9.8 mm, and the n+ doped region 3 also has a length of 156.75 mm the same as that of the n-type single crystal silicon substrate 1, and has a width W2=9.8 mm.

Please continue to refer to FIG. 1, where an anti-reflection laminated passivation film 5 is deposited on the front surface to passivate the n+ front surface field (FSF)4 with a low surface doping concentration, such as Al₂O₃/SiNx, SiO₂/SiNx, SiO₂/Al₂O₃/SiNx, etc., and SiO₂/SiNx is herein selected as the front surface passivation film with a film thickness of 60-200 nm; a reflection-enhancing laminated passivation film 6 is deposited on the back surface to perform partitioned passivation or simultaneous passivation for the n+ doped regions 3 and the p+ doped regions 2, the reflection-enhancing laminated passivation film 6 can be selected from Al₂O₃/SiNx, SiO₂/SiNx, SiO₂/SiCN, SiO₂/SiON, etc., and SiO₂/Al₂O₃/SiNx is herein selected as the back surface passivation film with a film thickness of 100 nm.

Please continue to refer to FIG. 1 and FIG. 2, where positive electrodes 21 composed of positive electrode fine grid lines are fabricated on the p+ doped regions 2, negative electrodes 31 composed of negative electrode fine grid lines are fabricated on the n+ doped region 3, the positive electrodes 21 and the negative electrodes 31 can adopt a manner of printing silver pastes to directly burn through the reflection-enhancing laminated passivation film 6 on the back surface, or adopt a manner of first performing laser-opening and then performing printing or electroplating metal to form an ohmic contact between the electrodes and the n-type single crystal silicon substrate 1 and lead out the current. Please refer to FIG. 2, where both the positive electrode 21 and the negative electrode 31 have a length of 156.75 mm the same as those of the p+ doped region 2, the n+ doped region 3 and the n-type single crystal silicon substrate 1, the positive electrode 13 has a width W3 of 100 µm, the negative electrode 43 has a width W4 of 100 µm, and the positive electrode fine grid lines and the negative electrode fine grid lines are arranged in an interdigital form.

### (2) Preparation of small cell pieces

Please refer to FIG. 3, where the aforesaid back contact type solar cell piece is cut to form four small back contact type solar cell pieces, and the small back contact type solar cell piece has a width L11=39.1875 mm. The n+ doped regions 3 and p+ doped regions 2 on the four small back contact type solar cell pieces are arranged in one-to-one correspondence, and at this time, the directions of all the small back contact type solar cell pieces are consistent with that of the original back contact type solar cell piece. The back surface of the small back contact type solar cell piece is only provided with negative electrode fine grid lines forming an ohmic contact with the elongated n+ doped regions 3, and positive electrode fine grid lines forming an ohmic contact with the p+ doped regions 2, and there is no main grid line for collecting currents of the elongated n+ doped regions 3 and p+ doped regions 2, respectively.

### (3) Preparation of a conductive strip 7

Please refer to FIG. 4, where the conductive patterns 72 are arranged on the substrate 71, the conductive pattern 72 is composed of several conductive fold lines arranged in parallel along the lengths of the rectangular strips, the conductive fold lines are stepped, and the conductive pattern 72 is dried for solidification on the substrate 71 by printing with a solder or a conductive adhesive. In this embodiment, the solder is used for printing, the material of the solder is a tin-lead alloy, and the solder is printed on the substrate 71 according to the aforesaid pattern and dried at 200°C for 2 minutes for solidification.

Please continue to refer to FIG. 4, where in this embodiment, the substrate 7 has a length L36=156.75 mm, and has a width L31 =19.6 mm. The fold lines of the conductive pattern 72 are stepped, each fold line has a width L32=1.5 mm, two adjacent fold lines has a distance L33=19.6mm therebetween, the stepped fold line has a height L34=9.8 mm, and each step of the stepped fold line has a width L35=9.8 mm.

### (4) Preparation of a cell string

Please refer to FIG. 5, where the conductive strips 4 are used to connect small full-back contact type solar cell pieces to each other in series to form a full-back contact type solar cell string, and the fine grid lines with opposite polarities of adjacent small back contact type solar cell pieces are connected to each other by the conductive patterns 72 composed of the solder on the substrate 71, so as to ensure that the current on the cell piece is led out along the long sides of the elongated n+ doped regions 3 and p+ doped regions 2.

### (5) Encapsulation for delivery

After the completion of the fabrication of the full-back contact type solar cell string, the subsequent module encapsulation processes such as confluence, stacking and lamination are the same as those of the conventional module fabricating manner.

### Embodiment 2

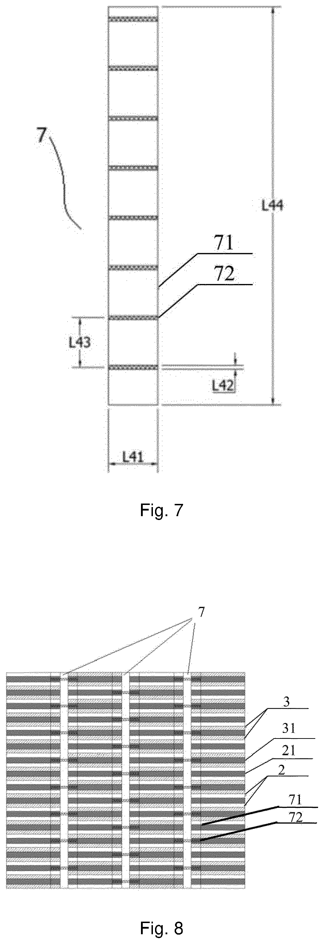

Please refer to FIG. 8, where it is different from Embodiment 1 that in this embodiment, four small back contact type solar cell pieces are arranged as shown in FIG. 6, that is, the n+ doped regions 3 and the p+ doped regions 2 are arranged in a staggered manner on two adjacent small cell pieces, and the width of the small cell piece as shown in FIG. 6 is L21. At this time, the directions of half of the small back contact type solar cell pieces are opposite to that of the original back contact type solar cell piece. The back surface of the small back contact type solar cell piece is only provided with silver grid lines forming an ohmic contact with the elongated n+ doped regions 3 and p+ doped regions 2, and there is no main grid line for collecting currents of the elongated n+ doped regions 3 and p+ doped regions 2, respectively.

Please refer to FIG. 7, where the conductive strip 7 in this embodiment is printed on the substrate 71 by a conductive adhesive to form conductive patterns 72, and the conductive adhesive is silver metal particles wrapped with epoxy resin as an adhesive. The shape of the conductive pattern is composed of several straight lines arranged in rows along the lengths of the rectangular strips. The conductive adhesive is printed on the substrate 71 according to the said shape, and dried at 200°C for 2 minutes for solidification. A conductive silicon wafer is selected for the substrate 71, and the conductive silicon wafer has a length L44=156.75 mm, and has a width L41 =19.6 mm. The straight lines arranged in parallel in the conductive pattern have a width L42=1.5 mm, and two adjacent straight lines has a distance L43=19.6 mm therebetween.

### Embodiment 3

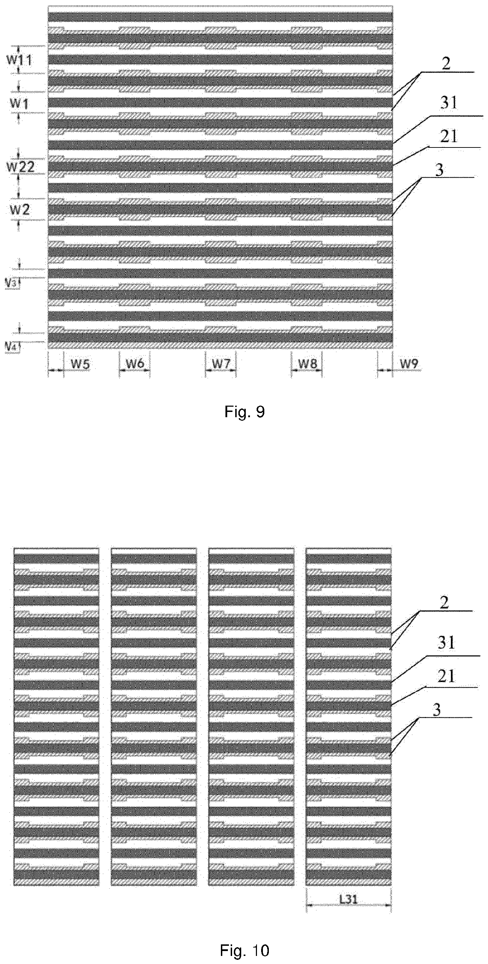

Please refer to FIG. 9, where it is different from Embodiment 1 that the p+ doped regions 2 and the n+ doped regions 3 on the n-type single crystal silicon substrate 1 present shapes with local different widths, which can be specifically understood as follows: the n+ doped region 3 is strip-shaped, including wide rectangular strips and narrow rectangular strips arranged in a staggered manner; the p+ doped region 2 is filled between two adjacent n+ doped regions 3, wherein the n+ doped region 3 has a length of 156.75 mm, the narrow rectangular strip in the n+ doped region 3 has a width W1=9.8 mm, and the wide rectangular strip in the n+ doped region 3 has a width W11=12.7 mm, and has a length W6=W7=W8=13.8 mm. Of course, due to the different cutting positions, the lengths W5 and W9 vary with different cuttings, but W5 and W9 had better be set to equal lengths. In this embodiment, W5=W19=6.9 mm.

The p+ doped region 2 filled between two adjacent n+ doped regions 3 has a length of 156.75 mm, and it can be understood that the p+ doped region 2 is also formed by connecting rectangular strips with different widths in a staggered manner. In this embodiment, the wider rectangular strip in the p+ doped region 3 has a width W2=9.8 mm, and the narrower rectangular strip therein has a width W22=6.9 mm.

In this embodiment, the aforesaid back contact type solar cell piece is cut to form four small back contact type solar cell pieces, and the small back contact type solar cell piece has a width L31 =39.1875 mm. The four small back contact type solar cell pieces are arranged as shown in FIG. 10, that is, the n+ doped regions 3 and the p+ doped regions 2 on two adjacent small cell pieces are arranged in one-to-one correspondence; at this time, the directions of all the small back contact type solar cell pieces are consistent with that of the original back contact type solar cell piece. The back surface of the small back contact type solar cell piece is only provided with silver grid lines forming an ohmic contact with the elongated n+ doped regions 3 and p+ doped regions 2, and there is no main grid line for collecting currents of the elongated n+ doped regions 3 and p+ doped regions 2, respectively.

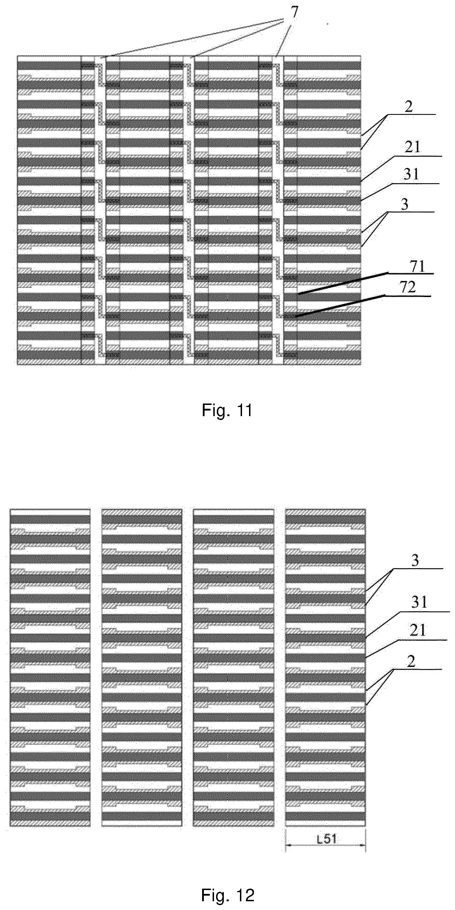

Please refer to FIG. 4, where the structure of the conductive strip is the same as that in Embodiment 1, the conductive strips 7 are used to connect the small full-back contact type solar cell pieces in this embodiment to each other in series to form a full-back contact type solar cell string, and the fine grid lines with opposite polarities of adjacent small back contact type solar cell pieces are connected to each other by the conductive patterns 72 composed of the solder on the substrate 71, so as to ensure that the current on the cell piece is led out along the long sides of the elongated n+ doped regions 3 and p+ doped regions 2. After the completion of the fabrication of the full-back contact type solar cell string, the subsequent module encapsulation processes such as confluence, stacking and lamination are the same as those of the conventional module fabricating manner. The finally obtained structure of the back contact type solar cell module is as shown in FIG. 11.

### Embodiment 4

It is different from Embodiment 3 that the back contact type solar cell piece provided in Embodiment 3 is cut. Please refer to FIG. 12, where four small back contact type solar cell pieces are formed after cutting, and the back contact type solar cell piece has a width L51=39.1875 mm. The four small back contact type solar cell pieces are arranged as shown in FIG. 12, that is, the n+ doped regions 3 and the p+ doped regions 2 on two adjacent small cell pieces are arranged in a staggered and corresponding manner, and at this time, the directions of half of the small back contact type solar cell pieces are opposite to that of the original back contact type solar cell piece. The back surface of the small back contact type solar cell piece is only provided with silver grid lines forming an ohmic contact with the elongated n+ doped regions 3 and p+ doped regions 2, and there is no main grid line for collecting currents of the elongated n+ doped regions 3 and p+ doped regions 2, respectively.

There is also a difference in the preparing process of the conductive strip 7. In this embodiment, the conductive pattern 72 on the substrate 71 is printed by a conductive adhesive. The conductive pattern 72 of the conductive strip 7 is composed of several straight lines arranged in parallel along the lengths of the rectangular strips, and the conductive adhesive is silver metal particles wrapped with epoxy resin as an adhesive. The conductive adhesive is printed on the substrate 71 according to the aforesaid pattern, and dried at 200°C for 2 minutes for solidification. Please continue to refer to FIG. 7, where a conductive silicon wafer is selected for the substrate 71, and the conductive silicon wafer has a length L44=156.75 mm, and has a width L41 =19.6 mm. The shape of the conductive pattern 72 is as shown in FIG. 7, where L42=1.5 mm, and L43=19.6 mm.

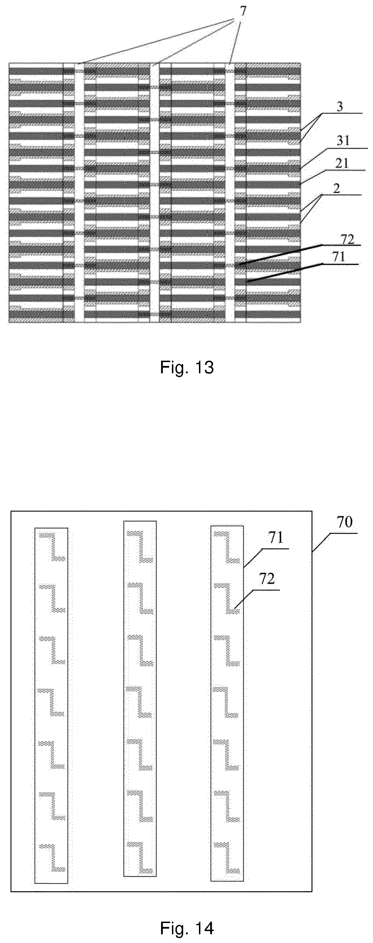

The aforesaid conductive strips 7 are used to connect the small full-back contact type solar cell pieces in this embodiment to each other in series to form a full-back contact type solar cell string, and the fine grid lines with opposite polarities of adjacent small back contact type solar cell pieces are connected to each other by the conductive patterns 72 composed of the solder on the substrate 71, so as to ensure that the current on the cell piece is led out along the long sides of the elongated n+ doped regions 3 and p+ doped regions 2. After the completion of the fabrication of the full-back contact type solar cell string, the subsequent module encapsulation processes such as confluence, stacking and lamination are the same as those of the conventional module fabricating manner. The finally obtained structure of the back contact type solar cell module is as shown in FIG. 13.

That the n+ doped regions and the p+ doped regions on two adjacent small cell pieces are arranged in a staggered and corresponding manner as mentioned in the aforesaid respective embodiments specifically refers to that in the two adjacent small cell pieces, the side surface of one small cell piece corresponds to the side surface of the other small cell piece, and the n+ doped regions 3 of one small cell piece and the n+ doped regions 3 of the other small cell piece are arranged in a staggered manner, and meanwhile the p+ doped regions 2 of one small cell piece and the p+ doped regions 2 of the other small cell piece are arranged in a staggered manner. That is, it is achieved that the n+ doped regions 3 of one small cell piece and the p+ doped regions 2 of the other small cell piece are arranged correspondingly, and the p+ doped regions 2 of one small cell piece and the n+ doped regions 3 of the other small cell piece are arranged correspondingly.

In addition, the silicon substrate may be also a p-type crystal silicon substrate or the like in addition to an n-type single crystal silicon substrate.

In addition, the resistivity of the silicon substrate can be 0-30 Ω•cm.

In addition, the thickness of the silicon substrate can be 50-300 µm.

It is worth noting that the side length of the silicon substrate 1 can be determined according to actual requirements. For example, the main surface of the existing commonly used silicon substrate 1 is square with a side length of 158.75 mm or the like, so in the actual production, the back contact type solar cell piece can be fabricated by the existing silicon substrate, then the back contact type cell pieces (the back contact type cell pieces are just small back contact type solar cell pieces or small cell pieces) used in the embodiments of the invention are obtained by cutting, and it will be described in detail later that the back contact type cell pieces/small back contact type solar cell pieces/small cell pieces used in the embodiments of the invention are obtained by cutting. In this way, the difficulty in fabricating the small back contact type solar cell pieces can be effectively reduced.

It is worth noting that a plurality of small back contact type solar cell pieces included in one back contact type solar cell module can be derived from a same back contact type solar cell piece or from different back contact type solar cell pieces. The back contact type solar cell piece can be obtained by using the existing back contact type solar cell piece fabricating process. Generally speaking, the back contact type solar cell piece can be cut into 2-200 small back contact type solar cell pieces, and 2-200 refers to any integer between 2 and 200, such as 4, 8, 20, 50, 80, 100, 150, etc. The specific number of the small back contact type solar cell pieces that are cut into can be determined by actual conditions such as the size of the back contact type solar cell piece, the size of the required small back contact type solar cell piece, and the cutting capacity of the process. In a preferred embodiment, the number of the small back contact type solar cell pieces into which one back contact type solar cell piece is cut is not less than 4.

In addition, it can be seen from the aforesaid respective embodiments that, for each small back contact type solar cell piece, the electrode contact fine grids with the same polarity on the same side of the small back contact type solar cell piece are connected to a conductive adhesive or solder. The positive electrode contact fine grids or the negative electrode contact fine grids on the same side of one small back contact type solar cell piece are connected to conductive patterns (e.g., conductive patterns composed of the conductive adhesive, etc.).

In addition, as shown in FIG. 5, FIG. 8, FIG. 16 and FIG. 17, the plurality of small back contact type solar cell pieces are arranged side by side, wherein the side surfaces of every two adjacent back contact type cell pieces are opposite; it is worth noting that the side surfaces of the small back contact type solar cell pieces include the side surfaces of the p+ doped regions 2 and the side surfaces of the n+ doped regions 3 alternately arranged, and the structure of the side surface of the small back contact type solar cell piece is consistent with the structure as shown in FIG. 1. The side-by-side arrangement can ensure the largest light-receiving surface area so as to ensure the electrical efficiency of the solar cell module.

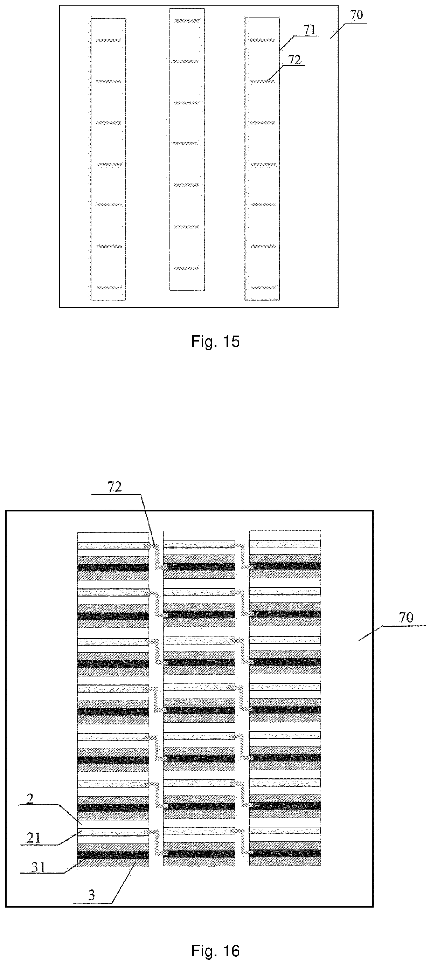

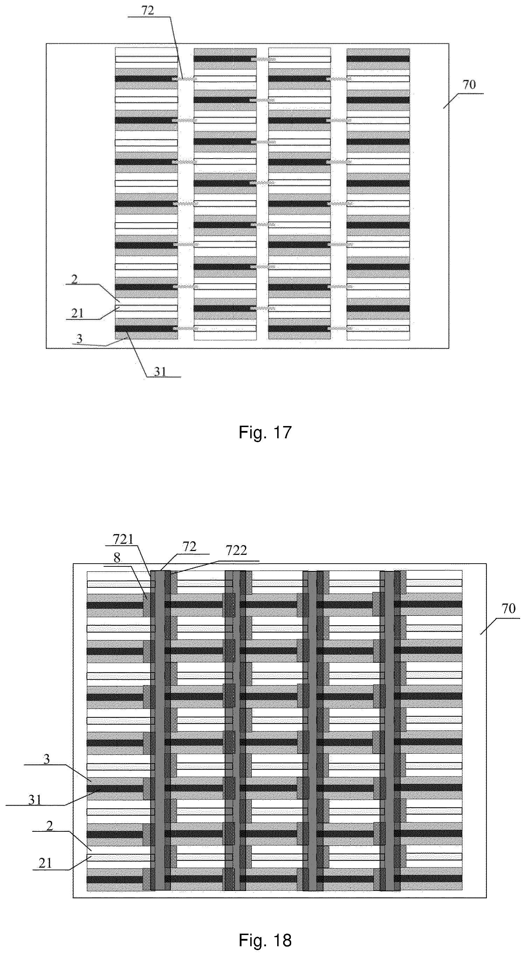

In the embodiments of the invention, as shown in FIG. 14 and FIG. 15, the (N-1) conductive strips (7) can be located on a same back plate 70, and each of the substrates 71 is a partial region of the back plate 70. It can be understood that the conductive patterns are arranged on the back plate 70. The back contact type solar cell module obtained by combining FIG. 3 and FIG. 14 is as shown in FIG. 16, and the back contact type solar cell module obtained by combining FIG. 6 and FIG. 15 is as shown in FIG. 17.

In the embodiments of the invention, the conductive pattern 72 as shown in FIG. 4, FIG. 7, FIG. 14 and FIG. 15 includes a plurality of sections of conductive adhesive or solder, and correspondingly, one electrode contact fine grid (positive electrode 21 or negative electrode 31) is only connected to one section of conductive adhesive, and only one end of one electrode contact fine grid is connected to the conductive adhesive or solder. The electrode contact fine grids with opposite polarities of adjacent small back contact type solar cell pieces are connected by the conductive adhesive or solder arranged on the back plate 70 to ensure that the current is led out.

The diameters of the positive electrode contact fine grid and the negative electrode contact fine grid can be 20-300 µm. The positive electrode contact fine grid may be in an ohmic contact with the p+ doped region, and the negative electrode contact fine grid may be in an ohmic contact with the n+ doped region.

The material of the positive electrode contact fine grid and the negative electrode contact fine grid is generally metallic silver. The positive electrode contact fine grids and the negative electrode contact fine grids can be fabricated in a manner of printing silver pastes to directly burn through the passivation film on the back surface, or in a manner of first performing laser-opening and then performing printing, or in a manner of electroplating metal or the like, thereby forming an ohmic contact of the positive electrode contact fine grids and the negative electrode contact fine grids with the silicon substrate and leading out the current.

In the embodiments of the invention, the structures of the two adjacent side surfaces of the adjacent p+ doped region 2 and n+ doped region 3 are complementary. For example, one of the two adjacent side surfaces of the p+ doped region 2 and the n+ doped region 3 has a protruding structure, so the other of the two adjacent side surfaces of the p+ doped region 2 and the n+ doped region 3 has a recessed structure complementary to or engaged with the protruding structure. For example, the two adjacent side surfaces of the p+ doped region 2 and the n+ doped region 3 have zigzag structures that mesh with each other; the two adjacent side surfaces of the p+ doped region 2 and the n+ doped region 3 have complementary square wave structures; the two adjacent side surfaces of the p+ doped region 2 and the n+ doped region 3 have complementary trapezoidal structures or the like. As shown in FIG. 9, the p+ doped regions 2 and the n+ doped regions 3 having complementary square wave shapes are exemplarily given.

In order to facilitate the display of the solar cell module, FIG. 3, FIG. 5, FIG. 6, FIG. 8, FIG. 16 and FIG. 17 only exemplarily give the rectangular structures of the p+ doped regions 2 and the n+ doped regions 3. Other structures such as a trapezoidal shape, a sawtooth shape, and a square wave shape can replace the rectangular structure to achieve the same effect.

It is worth noting that the silicon substrate has two opposite main surfaces. One of the main surfaces is subjected to texturing treatment before being used as the back surface of the silicon substrate for arranging the p+ doped regions and the n+ doped regions alternately arranged, and the other of the main surfaces is provided with a front surface electric field to serve as the front surface of the silicon substrate. The silicon substrate can be an n-type single crystal silicon substrate or a p-type single crystal silicon substrate. For the n-type single crystal silicon substrate, the front surface field is n+FSF, and for the p-type single crystal silicon substrate, the front surface field is p+FSF. In a preferred embodiment, the n-type single crystal silicon substrate is selected as the silicon substrate, and correspondingly, n+FSF is n+FSF with a low surface doping concentration.

Specifically, the relative relationship between two adjacent small back contact type solar cell pieces in the back contact type solar cell module may include the types below.

The first type: doped regions of the same type are arranged oppositely in two adjacent small back contact type solar cell pieces.

As shown in FIG. 3, FIG. 5 and FIG. 16, in two adjacent back contact type solar cell pieces, the p+ doped regions 2 of one back contact type solar cell piece and the p+ doped regions 2 of the other back contact type solar cell piece are arranged oppositely, and the n+ doped regions 3 of one back contact type solar cell piece and the n+ doped regions 3 of the other back contact type solar cell piece are arranged oppositely.

It is worth noting that FIG. 3, FIG. 5 and FIG. 16 only exemplarily give the case where the two ends of the small back contact type solar cell piece are respectively the n+ doped region 3 and the p+ doped region 2. The two ends of the small back contact type solar cell piece can be also both the n+ doped regions 3, and the two ends of the small back contact type solar cell piece can be also both the p+ doped regions 2 as long as the n+ doped regions 3 and the p+ doped regions 2 on the small back contact type solar cell piece are arranged alternately.

The second type: doped regions of opposite types are arranged oppositely in two adjacent small back contact type solar cell pieces.

As shown in FIG. 6, FIG. 8 and FIG. 17, in two adjacent small back contact type solar cell pieces, the p+ doped regions 2 of one small back contact type solar cell piece and the n+ doped regions 3 of the other small back contact type solar cell piece are arranged oppositely. It can be understood that the number of the p+ doped regions included in the two adjacent small back contact type solar cell pieces is equal to the number of the n+ doped regions included therein. In a comparatively preferred embodiment, for the aforesaid two types of the relative relationship between two adjacent small back contact type solar cell pieces, as shown in FIG. 3, FIG. 5, FIG. 6, FIG. 8, FIG. 16 and FIG. 17, the p+ doped regions 2 and the n+ doped regions 3 included between two adjacent small back contact type solar cell pieces are in one-to-one correspondence.

On this basis, for the first type of the relative relationship between two adjacent small back contact type solar cell pieces, the width of the p+ doped regions 2 included in one small back contact type solar cell piece is the same as the width of the p+ doped regions 2 included in the other adjacent small back contact type solar cell piece; the width of the n+ doped regions 3 included in one small back contact type solar cell piece is the same as the width of the n+ doped regions 3 included in the other adjacent small back contact type solar cell piece. That is, for two adjacent small back contact type solar cell pieces, the two opposite p+ doped regions 2 have the same width, and the two opposite n+ doped regions 3 have the same width. The widths of the plurality of p+ doped regions 2 belonging to the same small back contact type solar cell piece can be the same or different; the widths of the plurality of n+ doped regions 3 belonging to the same small back contact type solar cell piece can be the same or different. In a preferred embodiment, the widths of the plurality of p+ doped regions 2 belonging to the same small back contact type solar cell piece are the same, and the widths of the plurality of n+ doped regions 3 belonging to the same small back contact type solar cell piece are the same. In a more preferable embodiment, the widths of the plurality of p+ doped regions 2 and the plurality of n+ doped regions 3 belonging to the same small back contact type solar cell piece are all the same to facilitate the fabrication of the p+ doped regions and the n+ doped regions.

In addition, for the second type of the relative relationship between two adjacent small back contact type solar cell pieces, the widths of the p+ doped regions 2 and the n+ doped regions 3 that are opposite are the same. In a preferred embodiment, the widths of all of the p+ doped regions 2 and all of the n+ doped regions 3 in the small back contact type solar cell pieces are the same to facilitate the fabrication of the p+ doped regions and the n+ doped regions.

It is worth noting that the width of the p+ doped region 2 refers to the distance between the two boundary lines of the p+ doped region 2 with the n+ doped region, and when the p+ doped region 2 is rectangular, the width of the p+ doped region 2 can be the length of one side in the direction of the alternately arranged p+ doped regions and n+ doped regions.

It is worth noting that the alternate arrangement of the p+ doped regions and the n+ doped regions as stated in the respective embodiments is just the aforesaid staggered arrangement of the p+ doped regions and the n+ doped regions.

The width of the n+ doped region 3 refers to the distance between the two boundary lines of the n+ doped region 3 with the p+ doped region, and when the n+ doped region 3 is rectangular, the width of the n+ doped region 3 can be the length of one side in the direction of the alternately arranged p+ doped regions and n+ doped regions.

Generally speaking, the widths of the p+ doped region and the n+ doped region will affect the performance of the back contact type solar cell module, and the smaller the widths of the p+ doped region and the n+ doped region are, the larger the numbers of the p+ doped regions and the n+ doped regions included in one small back contact type solar cell piece are, and the better the performance of the solar cell module is. In the embodiments of the invention, the p+ doped region has a width of 0.1-20 mm; the n+ doped region has a width of 0.1-10 mm.

In addition, with respect to the relationship between two adjacent small back contact type solar cell pieces as shown in FIG. 3, the arrangement and relationship of the back contact type solar cell pieces that have been cut from the back contact type solar cell piece can be directly used for subsequent processes. With respect to the relationship as shown in FIG. 6, after the back contact type solar cell piece is cut into small back contact type solar cell pieces, it is required to horizontally rotate at intervals the small back contact type solar cell pieces arranged at odd positions or the small back contact type solar cell pieces arranged at even positions by 180 degrees (º) to achieve the relationship between two adjacent small back contact type solar cell pieces as shown in FIG. 6.

In the embodiments of the invention, with respect to the relationship between two adjacent small back contact type solar cell pieces as shown in FIG. 3 and FIG. 5, each section of conductive adhesive or conductive solder in the conductive pattern 72 has a Z-shaped structure or a Z-shaped variant structure or a stepped structure. In the back contact type solar cell module as shown in FIG. 5, one end of the conductive adhesive or conductive solder of the Z-shaped structure or the Z-shaped variant structure or the stepped structure is connected to one positive electrode contact fine grid (positive electrode 21), and the other end thereof is connected to one negative electrode contact fine grid (negative electrode 31) in the adjacent small back contact type solar cell piece; the positive electrode contact fine grids (positive electrodes 21) and the negative electrode contact fine grids (negative electrodes 31) connected by the conductive adhesive or conductive solder are in one-to-one correspondence; any two sections of conductive adhesive or conductive solder do not intersect. In the back contact type solar cell module as shown in FIG. 5, a plurality of conductive patterns can connect a plurality of small back contact type solar cell pieces in series.

With respect to the relationship between two adjacent small back contact type solar cell pieces as shown in FIG. 6, each section of conductive adhesive or conductive solder in the conductive pattern 72 has a linear structure. In the back contact type solar cell module as shown in FIG. 6, a plurality of conductive patterns connect a plurality of small back contact type solar cell pieces in series.

That is, in the back contact type solar cell module as shown in FIG. 5, FIG. 8, FIG. 16 and FIG. 17, a plurality of sections of conductive adhesive or conductive solder distributed in the conductive patterns between two adjacent small back contact type solar cell pieces are arranged in parallel in the direction of the alternately arranged p+ doped regions and n+ doped regions; in the two opposite sides of the two adjacent small back contact type solar cell pieces, the positive electrode contact fine grids located on one of the two opposite sides and one end of the conductive adhesive or conductive solder are connected in a one-to-one manner; the negative electrode contact fine grids located on the other of the two opposite sides and the other end of the conductive adhesive or conductive solder are connected in a one-to-one manner; every two sections of conductive adhesive or conductive solder do not intersect.

In the embodiments of the invention, the relationship between the plurality of small back contact type solar cell pieces in the back contact type solar cell module may include a combination of relationships that doped regions of the same type are arranged oppositely in two adjacent small back contact type solar cell pieces, and doped regions of opposite types are arranged oppositely in two adjacent small back contact type solar cell pieces.

In the embodiments of the invention, the structure of a plurality of sections of conductive adhesive or conductive solder may be any combination of a linear structure, a Z-shaped variant structure and a stepped structure. Generally speaking, the structures of the plurality of sections of conductive adhesive or conductive solder located between the same group of two adjacent small back contact type solar cell pieces are the same.

It is worth noting that FIGS 5, FIG. 8, FIG. 16 and FIG. 17 only show several relationships between two adjacent small back contact type solar cell pieces and several structural combination forms of the conductive adhesive or conductive solder, that is, the same back contact type solar cell module only includes one relationship between two adjacent small back contact type solar cell pieces and one structure of the conductive adhesive or conductive solder, which can effectively simplify the fabricating process and the fabricating cost of the solar cell module. The relationship between the plurality of small back contact type solar cell pieces in the back contact type solar cell module can be also a combination of the relationships in FIG. 5 and FIG. 8, and the structure of the plurality of sections of conductive adhesive or conductive solder provided on the back plate can be also a combination of the aforesaid multiple structures of the conductive adhesive or conductive solder. Other deformed structures based on the back contact type solar cell module as shown in FIG. 5 to FIG. 8 are also within the scope of protection of the embodiments of the invention.

It is worth noting that one end of the conductive adhesive or conductive solder being connected to one positive electrode contact fine grid may be that one end of the conductive adhesive or conductive solder is in an ohmic contact with the positive electrode contact fine grid, and the other end of the conductive adhesive or conductive solder being connected to one negative electrode contact fine grid of the adjacent small back contact type solar cell piece may be that the other end of the conductive adhesive or conductive solder is in an ohmic contact with the negative electrode contact fine grid.

In the embodiments of the invention, the conductive adhesive includes: a binder and metallic particles dispersed in the binder. Such conductive adhesive can effectively ensure the current transmission and ensure the adhesion between the positive and negative electrode contact fine grids and the conductive adhesive.

In the embodiments of the invention, as shown in FIGS. 18 to 21, FIG. 25 and FIG. 28, another back contact type solar cell module is provided, and the back contact type solar cell module may comprise: a plurality of small back contact type solar cell pieces, and a back plate provided with at least one section of conductive adhesive, wherein:
as shown in FIG. 1, the small back contact type solar cell piece includes: a silicon substrate 1, p+ doped regions 2 and n+ doped regions 3 alternately arranged on the back surface of the silicon substrate 1, positive electrode fine grids (positive electrodes 21) arranged on the p+ doped regions, and negative electrode fine grids (negative electrodes 31) arranged on the n+ doped regions 3;
as shown in FIG. 18 to FIG. 21, FIG.25 and FIG. 28, the plurality of small back contact type solar cell pieces are arranged side by side, wherein the side surfaces of every two adjacent small back contact type solar cell pieces are opposite;
in the two opposite sides of two adjacent small back contact type solar cell pieces, a positive electrode contact fine grid end on one of the two opposite sides is electrically isolated from the side, and a negative electrode contact fine grid end on the other of the two opposite sides is electrically isolated from the other side;
each section of conductive adhesive is distributed between two adjacent small back contact type solar cell pieces;
each section of conductive adhesive is connected to the negative electrode contact fine grid of one small back contact type solar cell piece and the positive electrode contact fine grid of the other adjacent small back contact type solar cell piece.

In addition, the sizes of the plurality of small back contact type solar cell pieces in the back contact type solar cell module can be the same, or can be not completely the same, or can be completely different. However, the types of the plurality of small back contact type solar cell pieces in the back contact type solar cell module must be consistent. For example, all of the small back contact type solar cell pieces are of the back contact type, and all of them have alternately arranged p+ doped regions and n+ doped regions.

The relative relationship between two adjacent small back contact type solar cell pieces can be any one of the relative relationships as shown in FIGS. 18 to 21, FIG. 25 and FIG. 28.

There may be multiple manners for achieving the electrical isolation. For example, the electrical isolation is achieved by insulating encapsulation layers, insulating layers or the like arranged between the back plate and the plurality of small back contact type solar cell pieces, and the electrical isolation can be also directly achieved by a reflection-enhancing laminated passivation film deposited on the small back contact type solar cell pieces or the like.

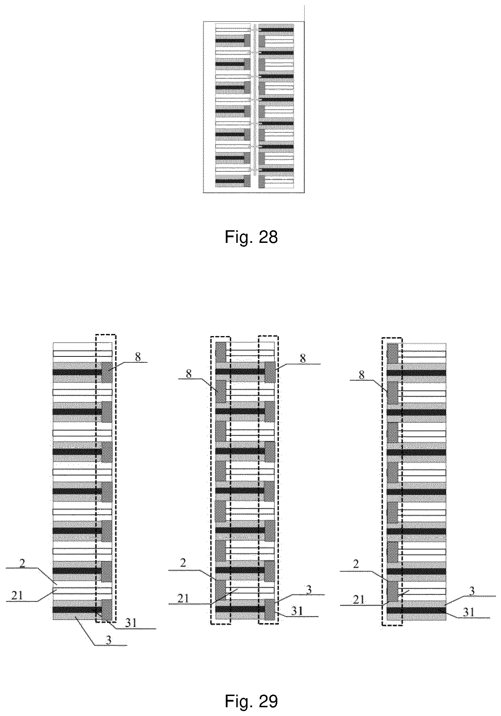

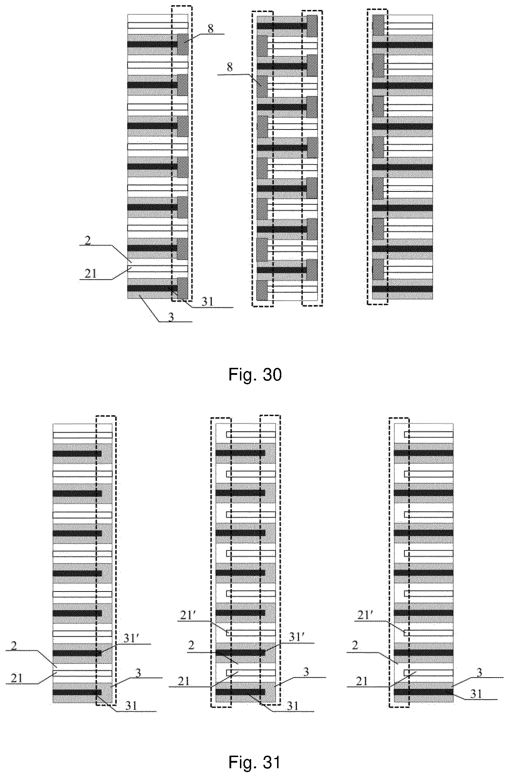

In an embodiment, the manners for achieving the electrical isolation by insulating layers are as follows:
In the two opposite sides of two adjacent small back contact type solar cell pieces, the positive electrode contact fine grid end on one side is covered by an insulating layer, and the negative electrode contact fine grid end on the other side is covered by an insulating layer. The arrangement of the insulating layers can effectively reduce the probability of errors of series connections, and can also reduce the occurrence of leakage. In a preferred embodiment, as shown in FIG. 29, based on the aforesaid first type of the relative relationship between two adjacent small back contact type solar cell pieces, in the two opposite sides of two adjacent small back contact type solar cell pieces, the positive electrode contact fine grid end on one side is covered by an insulating layer 8, and the negative electrode contact fine grid end on the other side is covered by an insulating layer 8. As shown in FIG. 30, based on the aforesaid second type of the relative relationship between two adjacent small back contact type solar cell pieces, in the two opposite sides of the two adjacent small back contact type solar cell pieces, the positive electrode contact fine grid end on one side is covered by an insulating layer 8, and the negative electrode contact fine grid end on the other side is covered by an insulating layer 8. It can be understood that one side and the other side are only used for distinguishing the two opposite sides of the two adjacent small back contact type solar cell pieces.

It is worth noting that the width of the insulating layer as shown in FIG. 29 and FIG. 30 is generally not smaller than the width of the electrode contact fine grid covered by the insulating layer. In a preferred embodiment, the width of the insulating layer is generally not smaller than the width of the doped region in which the insulating layer is located, but one insulating layer will not cover the contact fine grids with opposite polarities at the same time.

It can be understood that when both sides of the same small back contact type solar cell piece are provided with insulating layers, the insulating layers on the both sides are located on the opposite electrode contact fine grids. The aforesaid arrangement can effectively shorten the length of the circuit between the positive electrode contact fine grid and the negative electrode contact fine grid, thereby reducing the resistance loss brought in the transmission process, so as to reduce the power loss while simplifying the fabricating process of the back contact type solar cell module, thereby effectively improving the photoelectric conversion efficiency. In addition, the aforesaid insulating layer can avoid leakage caused by the electrode contact fine grids burning through the reflection-enhancing laminated passivation film on the surfaces of the p+ doped region and the n+ doped region, thereby further improving the stability of the back contact type solar cell module.

In another embodiment, the manner of the electrical isolation is achieved by the reflection-enhancing laminated passivation film deposited on the small back contact type solar cell piece.

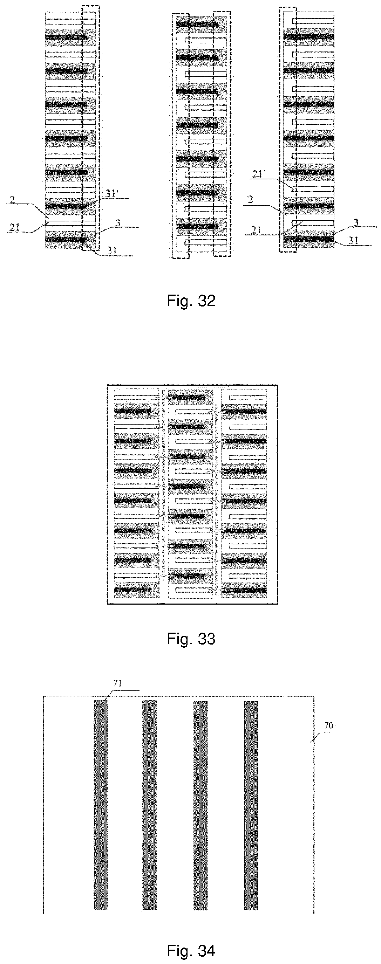

In the two opposite sides of two adjacent small back contact type solar cell pieces, the positive electrode contact fine grid end on one side is a shortened end, the negative electrode contact fine grid end on the other side is a shortened end, and an insulating layer is covered between the shortened end and its adjacent side. The arrangement of the shortened ends can effectively reduce the probability of errors of series connections, and can also reduce the occurrence of leakage. In a preferred embodiment, as shown in FIG. 31 and FIG. 32, in the opposite sides of two adjacent small back contact type solar cell pieces, the positive electrode contact fine grid end on one side is a shortened end 21' relative to the side, the negative electrode contact fine grid end on the other side 117 is a shortened end 31' relative to the other side, and a reflection-enhancing laminated passivation film 6 is deposited on the surfaces of the p+ doped regions 2 and the n+ doped regions 3. The aforesaid arrangement can effectively shorten the length of the circuit between the positive electrode contact fine grid and the negative electrode contact fine grid, thereby reducing the resistance loss brought in the transmission process, so as to reduce the power loss while simplifying the fabricating process of the back contact type solar cell module, thereby effectively improving the photoelectric conversion efficiency.

In the embodiments of the invention, on the basis of FIG. 31 and FIG. 32, in order to further enhance the electrical isolation, the positive electrode contact fine grid end on one side is a shortened end 21' relative to the side, the negative electrode contact fine grid end on the other side is a shortened end 31' relative to the other side, and the p+ doped region between the shortened end 21' and its opposite side is covered by an insulating layer; the n+ doped region between the shortened end 31' and its opposite other side is covered by an insulating layer. The aforesaid process can further improve the insulation.

The shortened end refers to that one end of one electrode contact fine grid (positive electrode contact fine grid end or negative electrode contact fine grid end) is shortened relative to one side belonging to the same small back contact type solar cell piece as the electrode, and the side is one of the two opposite sides of two adjacent small back contact type solar cell pieces.

It is worth noting that the size of the aforesaid insulating layer can be set according to actual conditions (e.g., the size of the small back contact type solar cell piece, the length of the positive electrode contact fine grid, and the length of the negative electrode contact fine grid). The distance between the shortened end and the side surface of the small back contact type solar cell piece close thereto generally can be set according to the actual conditions.

In the back contact type solar cell module provided by the embodiments of the invention, the distance between adjacent small back contact type solar cell pieces can be as close as possible, which can effectively shorten the length of the current transmission circuit between the positive electrode contact fine grid and the negative electrode contact fine grid while reducing the amount of the conductive adhesive, thereby reducing the resistance loss brought in the transmission process.

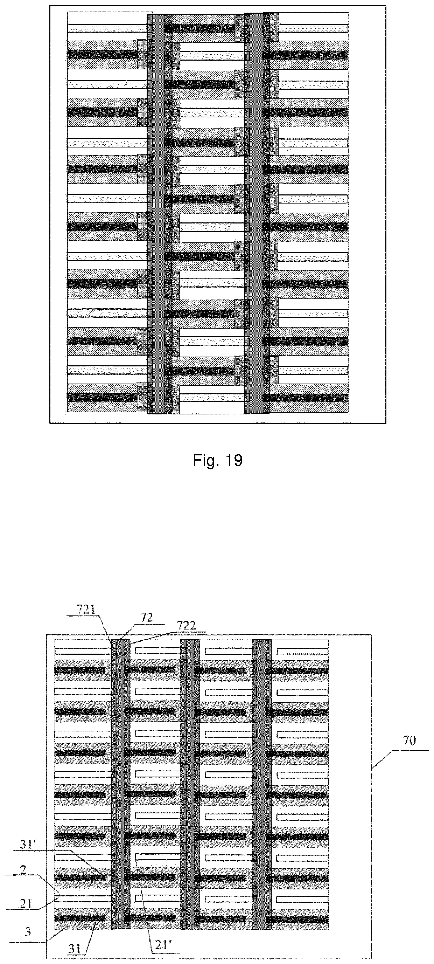

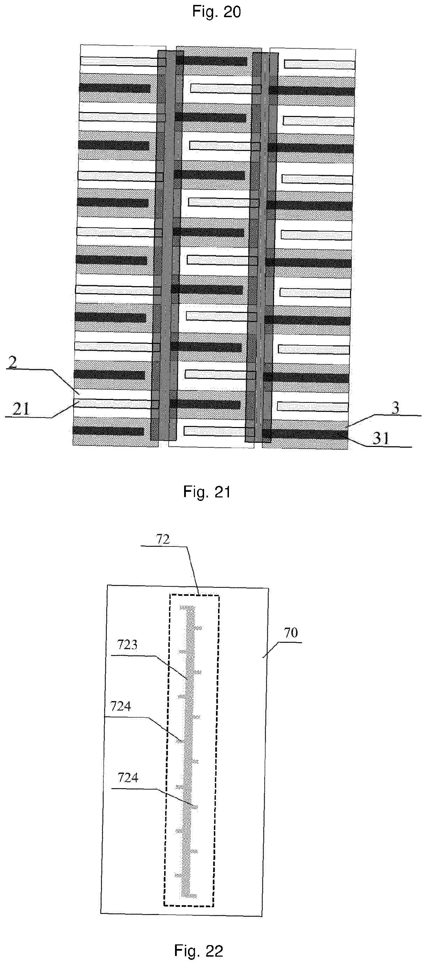

In the embodiments of the invention, a back contact type solar cell module as shown in FIG. 18 is obtained by combining the relationship between two adjacent small back contact type solar cell pieces and the elongated structure of the conductive adhesive arranged on the back plate 70 as shown in FIG. 29. A back contact type solar cell module 10 as shown in FIG. 19 is obtained by combining the relationship between two adjacent small back contact type solar cell pieces and the elongated structure of the conductive adhesive arranged on the back plate 70 as shown in FIG. 30. A back contact type solar cell module 10 as shown in FIG. 20 is obtained by combining the relationship between two adjacent small back contact type solar cell pieces and the elongated structure of the conductive adhesive arranged on the back plate 70 as shown in FIG. 31, and a back contact type solar cell module as shown in FIG. 21 is obtained by combining the relationship between two adjacent small back contact type solar cell pieces and the elongated structure of the conductive adhesive arranged on the back plate 70 as shown in FIG. 32. In the back contact type solar cell module as shown in FIG. 18 to FIG. 21, in the two opposite sides of two adjacent small back contact type solar cell pieces, all the positive electrode contact fine grids on one side are connected to one long side 721 having an elongated structure, and all the negative electrode contact fine grids on the side are not connected to the long side 721; all the negative electrode contact fine grids on the other side are connected to the other long side 722 having an elongated structure, and all the positive electrode contact fine grids on the side are not connected to the other long side 722. That is, two adjacent small back contact type solar cell pieces can be connected in series by the conductive adhesive arranged on the back plate 70, which effectively simplifies the series connection process of the small back contact type solar cell pieces and the fabricating process of the solar cell module.

It is worth noting that since the insulating layer is to prevent the positive electrode contact fine grid or negative electrode contact fine grid covered thereby from contacting the conductive adhesive, the two long sides of the conductive adhesive are located on the insulating layer and will not exceed the limitation of the edge of the insulating layer.

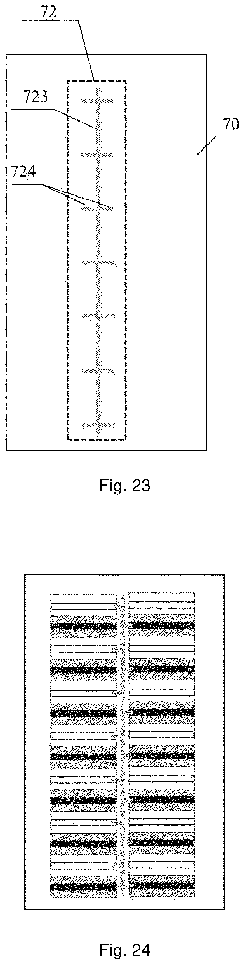

In the embodiments of the invention, based on any one of the relationships between two adjacent small back contact type solar cell pieces as shown in FIG. 3, FIG. 6 and FIGS. 29 to 32, the structure of the conductive adhesive located between two adjacent small back contact type solar cell pieces can be also as shown in FIG. 22 and FIG. 23, where the conductive adhesive located between two adjacent small back contact type solar cell pieces includes: an elongated main body 723 and a plurality of branch sections 724 connected to the elongated main body that are separately arranged on both sides of the elongated main body 723, wherein each branch section 724 on one side of the elongated main body 723 and one positive electrode contact fine grid of one of the adjacent small back contact type solar cell pieces, and each branch section 724 on the other side of the elongated main body 723 and one negative electrode contact fine grid of the other of the adjacent small back contact type solar cell pieces.

The structure of the conductive adhesive as shown in FIG. 22 and FIG. 23 can ensure the consistency of the conductive adhesive between two adjacent small back contact type solar cell pieces, which effectively reduces the inclination of the conductive adhesive arranged on the back plate, thereby ensuring the passing rate of products fabricated by the process (e.g., a back plate and a solar cell module provided with a conductive adhesive).

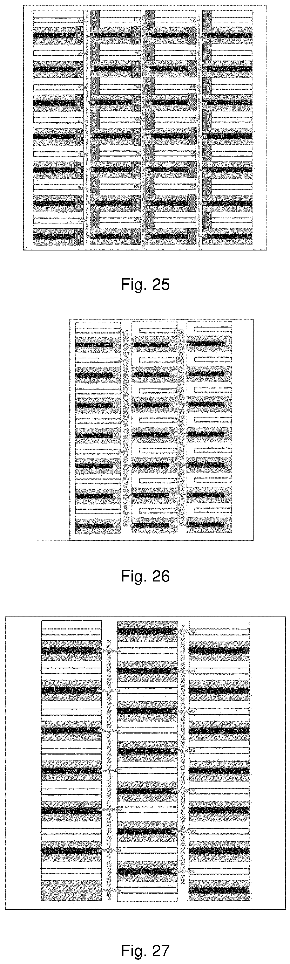

The structure of the conductive adhesive structure as shown in FIG. 22 is adopted, in which structure a plurality of branch sections 724 separately arranged on both sides of the elongated main body 723 are alternately arranged. Taking the application of the conductive adhesive as shown in FIG. 22 to the structure as shown in FIG. 3 as an example, a back contact type solar cell module as shown in FIG. 24 is obtained. Taking the application of the conductive adhesive as shown in FIG. 22 to the structure as shown in FIG. 29 as an example, a back contact type solar cell module as shown in FIG. 25 is obtained. The conductive adhesive as shown in FIG. 22 is applied to FIG. 31 to obtain a back contact type solar cell module as shown in FIG. 26.

For the relationship between two adjacent small back contact type solar cell pieces as shown in FIG. 6, FIG. 30 and FIG. 32, the structure of the conductive adhesive as shown in FIG. 23 is adopted. Every two branch sections 724 separately arranged on both sides of the elongated main body 723 are opposite. Taking the application of the conductive adhesive as shown in FIG. 23 to the structure as shown in FIG. 6 as an example, a back contact type solar cell module as shown in FIG. 27 is obtained. Taking the application of the conductive adhesive as shown in FIG. 23 to the structure as shown in FIG. 30 as an example, a back contact type solar cell module as shown in FIG. 28 is obtained. Taking the application of the conductive adhesive as shown in FIG. 23 to the structure as shown in FIG. 32 as an example, a back contact type solar cell module as shown in FIG. 33 is obtained.

It is worth noting that FIG. 3, FIG. 4 and FIGS. 29 to 32 only show several relationships between two adjacent small back contact type solar cell pieces and several structural combination forms of the conductive adhesive, that is, the same back contact type solar cell module only includes one relationship between two adjacent small back contact type solar cell pieces and one structure of the conductive adhesive, which can effectively simplify the fabricating process and the fabricating cost of the solar cell module.

In the embodiments of the invention, the back contact type solar cell module may comprise: multiple combinations of the relationships between a plurality of small back contact type solar cell pieces and the structures of a plurality of sections of conductive adhesive arranged on the back plate as shown in FIG. 5, FIG. 8, FIGS. 18 to 21, FIGS. 24 to 28 and FIG. 33.

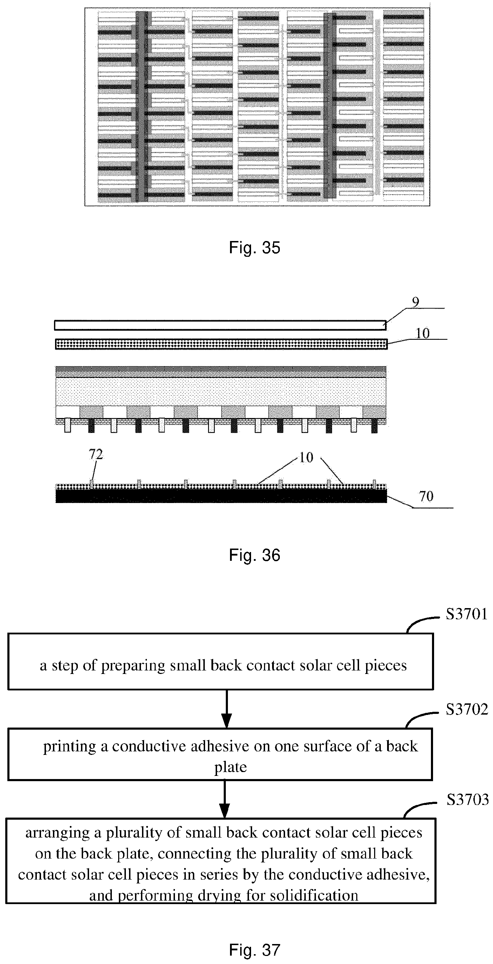

That is, the back contact type solar cell module may comprise: at least two groups of two adjacent small back contact type solar cell pieces, wherein the doped regions of the same type between at least one group of two adjacent small back contact type solar cell pieces are arranged oppositely, the p+ doped regions on one small back contact type solar cell piece and the n+ doped regions on the other small back contact type solar cell piece between the remaining two adjacent small back contact type solar cell pieces are arranged oppositely; in the two opposite sides of at least one group of two small back contact type solar cell pieces, the positive electrode contact fine grid end on one of the two opposite sides is electrically isolated from the side, and the negative electrode contact fine grid end on the other of the two opposite sides is electrically isolated from the other side, wherein two adjacent small back contact type solar cell pieces that are electrically isolated are connected by the elongated conductive adhesive arranged on the back plate as shown in FIG. 34 or the branch sections of the conductive adhesive, which are distributed on both sides of the main body structure, arranged on the back plate as shown in FIG. 22 or FIG. 23; two small back contact type solar cell pieces that are not electrically isolated are connected by a plurality of sections of conductive adhesive arranged on the back plate, the structure of the plurality of sections of conductive adhesive can be any one of a linear structure as shown in FIG. 15, a Z-shaped variant structure as shown in FIG. 14, a stepped structure, and branch sections of the conductive adhesive connected to the main body structure of the conductive adhesive as shown in FIG. 22 and FIG. 23. FIG. 35 exemplarily shows a back contact type solar cell module, which comprises a combination of multiple structures. Other deformed structures based on the back contact type solar cell module as shown in FIGS. 16 to 21 and FIGS. 24 to 28 are also within the scope of protection of the embodiments of the invention.

In the embodiments of the invention, as shown in FIG. 36, the solar cell module may further comprise: a first encapsulation layer (encapsulation layer 10) filled between the plurality of small back contact type solar cell pieces and the back plate 70. The first encapsulation layer (encapsulation layer 10) can fill the gap between the contact cell piece and the back plate 70, so as to further improve the performance of the solar cell module. In addition, the first encapsulation layer can better fix the small back contact type solar cell pieces on the back plate, so as to facilitate the transportation and placement or storage of the solar cell module.

In the embodiments of the invention, as shown in FIG. 36, the back contact type solar cell module may further comprise: a glass plate 9 and a second encapsulation layer (encapsulation layer 10), wherein:
the glass plate 9 is opposite to the plurality of small back contact type solar cell pieces;
the second encapsulation layer (encapsulation layer 10) is arranged between the glass plate 9 and the plurality of small back contact type solar cell pieces;
the first encapsulation layer and the second encapsulation layer are used for encapsulating the plurality of small back contact type solar cell pieces between the glass plate 9 and the back plate 70.

In addition, the aforesaid solar cell module further comprises a bus bar for collecting and leading out the module currents (not shown in the figure), which is consistent with the existing back contact type solar cell module in terms of the position and connection manner, and no unnecessary details are further given herein.

As for the back contact type solar cell module provided by the aforesaid embodiments, on the one hand, since the main grid is completely abandoned, the main grid is no longer required to be considered in the process of arranging the positive electrode contact fine grids and the negative electrode contact fine grids; on the other hand, the conductive adhesive is arranged on the back plate, which achieves the fixation of the conductive adhesive, and facilitates the use of the fixed conductive adhesive to connect a plurality of small back contact type solar cell pieces in series. Thus, the solution provided by the embodiments of the invention simplifies the fabricating process of the full-back contact type solar cell module.

In addition, since the conductive adhesive or solder can shorten the distance between a plurality of small back contact type solar cell pieces that are connected in series, and the conductive adhesive or solder as well as the positive electrode contact fine grids and the negative electrode contact fine grids can eliminate the lateral transmission loss and electrode shielding effect brought by the main grid, thereby improving the fill factor, and the stabilities of the photoelectric conversion efficiency and the photoelectric conversion efficiency of the full-back contact type solar cell module.

In addition, since each section of conductive adhesive or solder is connected to one positive electrode contact fine grid of one small back contact type solar cell piece and one negative electrode contact fine grid of the other adjacent small back contact type solar cell piece, the width of the conductive adhesive can be shortened as far as possible, which not only can save the material of the conductive adhesive, but also can reduce the resistance loss brought by the conductive adhesive or solder.

In addition, the whole back contact type solar cell module has no design of welding belts (e.g., the positive electrode contact fine grids and the negative electrode contact fine grids are connected in series) except for the confluence region, which greatly reduces the cost of the module. Meanwhile, the current of the back contact type solar cell module is subjected to the smallest resistance with the transmission path provided in the embodiments of the invention during the transmission between adjacent small back contact type solar cell pieces, which reduces the influence of the resistance loss on the electrode contact fine grids (the positive electrode contact fine grids and the negative electrode contact fine grids), thereby improving the fill factor of the module.

In addition, in the back contact type solar cell module given in the embodiments of the invention, the p+ doped region and the n+ doped region do not include an insulating band gap or an insulating layer therebetween. This arrangement can further simplify the fabricating process of the small back contact type solar cell piece or the back contact type solar cell module, and can also reduce the hot spot of the back contact type solar cell module, thereby effectively improving the service life of the solar cell module and the stability of the electrical efficiency.

In addition, since the plurality of sections of conductive adhesive are distributed between every two adjacent small back contact type solar cell pieces, and meanwhile one section of conductive adhesive or solder is connected to one positive electrode contact fine grid of one small back contact type solar cell piece and one negative electrode contact fine grid of the other adjacent small back contact type solar cell piece, the series circuits formed by the plurality of small back contact type solar cell pieces and the plurality of sections of conductive adhesive are relatively independent, that is, the positive electrode contact fine grids and the negative electrode contact fine grids are connected in series in a one-to-one manner, so that the current transmission paths are fixed and independent of each other, which can effectively reduce the interference of adjacent series circuits, avoid current dispersion and diffusion, can effectively reduce the current loss, thereby further improving the fill factor, and the stabilities of the photoelectric conversion efficiency and the photoelectric conversion efficiency of the full-back contact type solar cell module.

The embodiments of the invention provide a method for preparing a back contact type solar cell module. As shown in FIG. 37, the method for preparing a back contact type solar cell module may comprise the following steps:
S3701: a step of preparing small back contact type solar cell pieces;
S3702: printing a conductive adhesive on one surface of a back plate;
S3703: arranging a plurality of small back contact type solar cell pieces on the back plate, connecting the plurality of small back contact type solar cell pieces in series by the conductive adhesive, and performing drying for solidification.

The aforesaid preparing method can be used for preparing the solar cell module provided in the aforesaid respective embodiments.

The step of preparing small back contact type solar cell pieces may be as follows: using an existing fabricating process to fabricate the back contact type solar cell piece, and cutting the back contact type solar cell piece along the alternately arranged p+ doped regions and n+ doped regions to obtain a plurality of small back contact type solar cell pieces. The cutting process can be performed by laser or other methods.

Printing the conductive adhesive on one surface of the back plate may be printing the conductive adhesive on the back plate or applying the conductive adhesive on the back plate. The distribution of the conductive adhesive obtained in step S3702 on the back plate may be as shown in FIG. 14, FIG. 15, FIG. 22, FIG. 23 and FIG. 34, and one back plate may include the conductive adhesive with the same structure, which facilitates the process operation. The structure as shown in FIG. 14 is combined with the structure as shown in FIG. 3 to obtain the back contact type solar cell module as shown in FIG. 16; the structure as shown in FIG. 15 is combined with the structure as shown in FIG. 6 to obtain the back contact type solar cell module as shown in FIG. 17; the structure as shown in FIG. 22 is combined with the structure as shown in FIG. 3 to obtain the back contact type solar cell module as shown in FIG. 24; the structure as shown in FIG. 23 is combined with the structure as shown in FIG. 6 to obtain the back contact type solar cell module as shown in FIG. 27 and so on.

Thus, printing a plurality of sections of conductive adhesive on one surface of the back plate may include: printing a plurality of sections of elongated conductive adhesive arranged side by side, wherein the distance between two adjacent long sides of two adjacent sections of the elongated conductive adhesive is not greater than the length of the negative electrode contact fine grid or the positive electrode contact fine grid included in the small back contact type solar cell piece to obtain the back plate and the plurality of sections of conductive adhesive as shown in FIG. 34.

In addition, the printed plurality of sections of conductive adhesive obtained by the aforesaid step S3702 can be arranged in multiple rows and multiple columns, and each section of conductive adhesive has a linear structure or a Z-shaped variant structure as shown in FIG. 4 and FIG. 14.

It is worth noting that FIG. 14, FIG. 15, FIG. 22, FIG. 24 and FIG. 34 only exemplarily give several distributions of a plurality of sections of conductive adhesive printed on the back plate and/or several structures of the plurality of sections of conductive adhesive, and the other structures of the conductive adhesive, e.g., a Z-shaped structure or a combination of conductive adhesives of multiple structures, can be also obtained by the aforesaid step S3702.

In the embodiments of the invention, the temperature of drying for solidification is 100-500 degrees (°C). The temperature of drying for solidification can make the positive and negative electrode contact fine grids form a comparatively good ohmic contact with the conductive adhesive, so that the stability and electrical efficiency of the solar cell module can achieve comparatively good effects.

In the embodiments of the invention, the time of drying for solidification is 5-1800 s.

In order to clearly illustrate the method for preparing the solar cell module, several specific embodiments are described below.

In the embodiments below, the steps of preparing the back contact type solar cell piece are the same as those in Embodiments 1 to 4 described above, and the subsequent processes for preparing the conductive strips are different from those in Embodiments 1 to 4. The following illustrations will be directly given from the preparation of the conductive strips (printing the conductive adhesive on one surface of the back plate).

### Embodiment 5

The following steps are specifically included:
A1: A back plate printed with the conductive adhesive is prepared.

For example, the conductive adhesive is printed on the back plate according to the structure as shown in FIG. 14 (this process can be performed by giving a specific pattern corresponding to the structure as shown in FIG. 14 and adjusting the parameters of the specific pattern by the process or the like, so as to print the conductive adhesive on the back plate according to the specific pattern corresponding to the structure as shown in FIG. 14). It is worth noting that the back plate in the figure is only used for showing its use, and does not represent the real size and position information. The length and width of the conductive adhesive, the distance between the conductive adhesives or the like can be determined according to the actual conditions. For example, as shown in FIG. 14, the width of the section of the conductive adhesive in contact with the positive and negative electrode contact fine grids (i.e., the width of the two horizontal lines of the Z-shaped structure or the Z-shaped variant structure) is 1.5 mm, the length of the conductive adhesive is 9.9 mm (the length of the conductive adhesive is the distance between the center lines of the two horizontal lines of the Z-shaped structure or the Z-shaped variant structure), the distance between two adjacent sections of conductive adhesive located between the same group of two adjacent small back contact type solar cell pieces is 19.8 mm (the distance between the two adjacent sections of conductive adhesive is the distance between the center lines of the two horizontal lines of the two adjacent Z-shaped structures or Z-shaped variant structures having consistent positions on the Z-shaped structures or Z-shaped variant structures located between the same group of two adjacent small back contact type solar cell pieces), and the distance between two adjacent columns of conductive adhesive is 45 mm (the distance between the two adjacent columns of conductive adhesive is the distance between the positions on the same side of the conductive adhesive in the two columns of conductive adhesive).

A2: According to the arrangement of the conductive adhesive on the back plate, the positive electrode contact fine grids and the negative electrode contact fine grids in the small back contact type solar cell pieces are attached to the conductive adhesive to form solar cell modules connected to each other in series, and drying for solidification is performed at 200°C for 2 minutes. The solar cell module as shown in FIG. 16 is obtained.

The process is mainly that the electrode contact fine grids with opposite polarities of adjacent small back contact type solar cell pieces are connected to each other by the conductive adhesive printed on the back plate to ensure that the current on the cell piece is led out along the long sides of the elongated n+ and p+ doped regions.

### Embodiment 6

The following steps are specifically included:
B1: A back plate printed with the conductive adhesive is prepared.

For example, the conductive adhesive is printed on the back plate according to the structure as shown in FIG. 15 (this process can be performed by giving a specific pattern corresponding to the structure as shown in FIG. 15 and adjusting the parameters of the specific pattern by the process or the like, so as to print the conductive adhesive on the back plate according to the specific pattern corresponding to the structure as shown in FIG. 15). It is worth noting that the back plate in the figure is only used for showing its use, and does not represent the real size and position information. The length and width of the conductive adhesive, the distance between the conductive adhesives or the like can be determined according to the actual conditions. For example, as shown in FIG. 15, the width of the conductive adhesive is 1.5 mm, the length of the conductive adhesive is 5 mm, the distance between two adjacent sections of conductive adhesive located between the same group of two adjacent small back contact type solar cell pieces is 19.8 mm (the distance between the two adjacent sections of conductive adhesive is the distance between the center lines of the two sections of conductive adhesive), and the distance between two adjacent columns of conductive adhesive is 45 mm (the distance between the two adjacent columns of conductive adhesive is the distance between the positions on the same side of the conductive adhesive in the two columns of conductive adhesive).

B2: According to the arrangement of the conductive adhesive on the back plate, the positive electrode contact fine grids and the negative electrode contact fine grids in the small back contact type solar cell pieces are attached to the conductive adhesive to form solar cell modules connected to each other in series, and drying for solidification is performed at 300°C for 1 minute. The solar cell module as shown in FIG. 17 is obtained.

The process is mainly that the electrode contact fine grids with opposite polarities of adjacent small back contact type solar cell pieces are connected to each other by the conductive adhesive printed on the back plate to ensure that the current on the cell piece is led out along the long sides of the elongated n+ and p+ doped regions.

### Embodiment 7

The following steps are specifically included:
C1: The insulating layers covering the positive electrode contact fine grid and the negative electrode contact fine grid are provided at the specific positions on the back contact type solar cell piece obtained in the step (A1) of Embodiment 1, respectively.

The specific positions may be the corresponding positions provided with the insulating layers as shown in FIG. 29 or FIG. 30.

C2: The back contact type solar cell piece obtained in the aforesaid step C1 is cut to form 5 small back contact type solar cell pieces.

The width of the small back contact type solar cell piece can be set according to actual requirements. For example, the widths of the respective small back contact type solar cell pieces that are cut into are different. In a comparatively preferred embodiment, the widths of the respective small back contact type solar cell pieces that are cut into are the same, which facilitates the process operation and the process achievement. For example, the width of each small back contact type solar cell piece is 26.4583 mm. These 5 small back contact type solar cell pieces are arranged as shown in FIG. 18. At this time, the directions of part of the small back contact type solar cell pieces are inconsistent with that of the original back contact type solar cell piece. There are the positive electrode contact fine grids and the negative electrode contact fine grids, and there is no main grid line for collecting currents of the elongated n+ doped regions and p+ doped regions, respectively.

C3: A back plate printed with the conductive adhesive is prepared.

For example, the conductive adhesive is printed on the back plate according to the structure as shown in FIG. 34 (this process can be performed by giving a specific pattern corresponding to the structure as shown in FIG. 34 and adjusting the parameters of the specific pattern by the process or the like, so as to print the conductive adhesive on the back plate according to the specific pattern corresponding to the structure as shown in FIG. 34). It is worth noting that the back plate in the figure is only used for showing its use, and does not represent the real size and position information. The length and width of the conductive adhesive, the distance between the conductive adhesives or the like can be determined according to the actual conditions.

C4: According to the arrangement of the conductive adhesive on the back plate, the positive electrode contact fine grids and the negative electrode contact fine grids in the small back contact type solar cell pieces are attached to the conductive adhesive to form solar cell modules connected to each other in series, and drying for solidification is performed at 150°C for 5 minutes. The solar cell module as shown in FIG. 18 is obtained.

The process is mainly that the electrode contact fine grids with opposite polarities of adjacent small back contact type solar cell pieces are connected to each other by the conductive adhesive printed on the back plate to ensure that the current on the cell piece is led out along the long sides of the elongated n+ and p+ doped regions.

### Embodiment 8

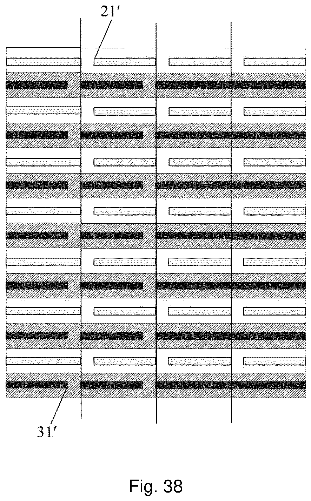

The following steps are specifically included:
D1: In the process of the step (1) of preparation of a back contact type solar cell piece as shown in Embodiment 1, during the fabrication of the positive electrode contact fine grids and the negative electrode contact fine grids, it is required to fabricate a plurality of sections of positive electrode contact fine grids in each p+ doped region, and fabricate a plurality of sections of negative electrode contact fine grids in each n+ doped region to obtain the structure as shown in FIG. 38. The length of each section of positive electrode contact fine grids and negative electrode contact fine grids, the distance between two adjacent sections of positive electrode contact fine grids, and the distance between two adjacent sections of negative electrode contact fine grids can be set according to requirements. By adjusting the process parameters, it is achieved to fabricate a plurality of sections of positive electrode contact fine grids in each p+ doped region and a plurality of sections of negative electrode contact fine grids in each n+ doped region.

The positive electrode contact fine grids and the negative electrode contact fine grids can be fabricated by printing silver pastes to directly burn through the passivation film on the back side, or adopt a manner of first performing laser-opening and then performing printing or electroplating metal, thereby forming an ohmic contact of the positive electrode contact fine grids and the negative electrode contact fine grids with the silicon substrate and leading out the current, wherein the widths of the positive electrode contact fine grid and the negative electrode contact fine grid can be both 100 µm. The lengths of the positive electrode contact fine grid and the negative electrode contact fine grid can be adjusted correspondingly according to the structure of the fabricated solar cell module.

D2: The back contact type solar cell piece obtained in the aforesaid step D1 is cut to form 4 small back contact type solar cell pieces.

The width of the small back contact type solar cell piece can be set according to actual requirements. For example, the widths of the respective small back contact type solar cell pieces that are cut into are different. In a comparatively preferred embodiment, the widths of the respective small back contact type solar cell pieces that are cut into are the same, which facilitates the process operation and the process achievement. For example, the width of each small back contact type solar cell piece is 39.6875 mm. These 4 small back contact type solar cell pieces are arranged as shown in FIG. 31. At this time, the directions of part of the small back contact type solar cell pieces are inconsistent with that of the original back contact type solar cell piece. There are the positive electrode contact fine grids and the negative electrode contact fine grids, and there is no main grid line for collecting currents of the elongated n+ doped regions and p+ doped regions, respectively.

D3: A back plate printed with the conductive adhesive is prepared. This step is consistent with the step C3 as shown in Embodiment 7, and no unnecessary details are further given herein.

D4: According to the arrangement of the conductive adhesive on the back plate, the positive electrode contact fine grids and the negative electrode contact fine grids in the small back contact type solar cell pieces are attached to the conductive adhesive to form solar cell modules connected to each other in series, and drying for solidification is performed at 250°C for 3 minutes. The solar cell module as shown in FIG. 20 is obtained.

The process is mainly that the electrode contact fine grids with opposite polarities of adjacent small back contact type solar cell pieces are connected to each other by the conductive adhesive printed on the back plate to ensure that the current on the cell piece is led out along the long sides of the elongated n+ and p+ doped regions.

After the completion of the fabrication of the aforesaid solar cell module according to Embodiment 1 to Embodiment 8, the subsequent module encapsulation processes such as confluence, stacking and lamination are the same as those of the conventional module fabricating manner, and no unnecessary details are further given herein.

It is worth noting that the aforesaid parameters are only exemplarily given. For example, all the parameters of the width of each small back contact type solar cell piece, the widths of the p+ doped region and the n+ doped region, the distance between two adjacent small back contact type solar cell pieces, and the size of the conductive adhesive can be adjusted. For example, the length of the conductive adhesive can be adjusted to 1 mm, 500 µm, 200 µm or even smaller, and the width of the conductive adhesive can be also adjusted to 1 mm, 500 µm, 200 µm, 100 µm, 50 µm or even smaller. All of the other various parameters can be adjusted within the process achievement range, and no unnecessary details are further given herein.

Although the embodiments of the invention are disclosed as above, they are not intended to limit the scope of protection of the invention. For example, the relationships between two adjacent small back contact type solar cell pieces and the distributions of the conductive adhesive or the structures of the conductive adhesive on the back plate can be exchanged or combined, or the positions between the p+ doped regions and the n+ doped regions can be also exchanged, and meanwhile the positive electrode contact fine grids, the negative electrode contact fine grids and the like are adaptively adjusted; the back contact type solar cell can be also cut into more small back contact type solar cell pieces, and for another example, the width of the conductive adhesive can be infinitely small, such as 200 µm, and the distance between two adjacent small back contact type small solar cell pieces can be also infinitely small, such as smaller than 200 µm. Any changes and modifications made without departing from the concept and scope of the present application shall fall within the scope of protection of the present application.

## Claims

1. A back contact type solar cell module, **characterized by** comprising:
N small cell pieces, p+ doped regions (2) and n+ doped regions (3) arranged in a staggered manner being provided on the back surface of the small cell piece, the p+ doped regions (2) of the small cell piece being provided with positive electrode fine grid lines, the n+ doped regions of the small cell piece being provided with negative electrode fine grid lines, and each of the small cell pieces being not provided with a main grid line for collecting currents of the n+ doped regions and the p+ doped regions;
(N-1) conductive strips (7), each of which includes a substrate (71) and conductive patterns (72) provided on the substrate (71), each of the substrates (71) being provided between two adjacent small cell pieces, and the conductive patterns (72) being used for electrically connecting fine grid lines with opposite polarities on two adjacent small cell pieces at intervals in sequence so as to connect the respective small cell pieces in series.

2. The back contact type solar cell module as to claim 1, **characterized in that**:
the n+ doped regions (3) and the p+ doped regions (2) on two adjacent ones of the small cell pieces are arranged in one-to-one correspondence, the conductive pattern (72) is formed by several conductive fold lines arranged in rows, and the conductive fold lines are stepped.

3. The back contact type solar cell module as to claim 1, **characterized in that**:
the n+ doped regions (3) and the p+ doped regions (2) on two adjacent ones of the small cell pieces are arranged in a staggered and corresponding manner, and the conductive pattern (72) of the conductive strip (7) is formed by several straight lines arranged in rows.

4. The back contact type solar cell module as to any of claims 1 to 3, **characterized in that**:
the conductive pattern (72) includes a plurality of sections of conductive adhesive or a plurality of sections of solder.

5. The back contact type solar cell module as to claim 4, **characterized in that**:
each section of the conductive adhesive or each section of the solder is connected to one of the positive electrode contact fine grids of one of the small cell pieces and one of the negative electrode contact fine grids of the other adjacent one of the small cell pieces.

6. The back contact type solar cell module as to any of claims 1 to 3 and 5, **characterized in that**:
the small cell pieces are formed by cutting a back contact type solar cell piece.

7. The back contact type solar cell module of claim 1, **characterized in that**:
the (N-1) conductive strips (7) are located on a same back plate, and each of the substrates (71) is a partial region of the back plate.

8. The back contact type solar cell module as to any of claims 1 to 3, 5 and 7, **characterized in that**:
the structures of the two adjacent side surfaces of the adjacent p+ doped region (2) and n+ doped region (3) are complementary.

9. The solar cell module as to claim 8, **characterized in that**:
the structures of the p+ doped region (2) and the n+ doped region (3) are any one of a rectangular structure, a trapezoidal shape, a sawtooth shape, and a square wave shape;
or,
the n+ doped region (3) is strip-shaped, including wide rectangular strips and narrow rectangular strips arranged in a staggered manner; the p+ doped region (2) is filled between two adjacent n+ doped regions (3).

10. The solar cell module as to claims 1 to 3, 5, 7 and 9, **characterized in that**:
the relationship between the N small cell pieces includes: a combination of relationships that doped regions of the same type are arranged oppositely in two adjacent small cell pieces, and doped regions of opposite types are arranged oppositely in two adjacent small cell pieces.

11. The solar cell module as to claims 1 to 3, 5, 7 and 9, **characterized in that**:
the substrate (71) has an expansion coefficient close to that of silicon.

12. The solar cell module as to claims 1 to 3, 5, 7 and 9, **characterized in that**:
the substrate (71) is a conductive silicon wafer.

13. A back contact type solar cell module, **characterized by** comprising: a plurality of small back contact type solar cell pieces, and a back plate (70) provided with at least one section of conductive adhesive, wherein:
the small back contact type solar cell piece includes: a silicon substrate (1), p+ doped regions (2) and n+ doped regions (3) alternately arranged on the back surface of the silicon substrate, positive electrode fine grids arranged on the p+ doped regions, and negative electrode fine grids arranged on the n+ doped regions;
the plurality of small back contact type solar cell pieces are arranged side by side, wherein the side surfaces of every two adjacent ones of the small back contact type solar cell pieces are opposite;
in the two opposite sides of two adjacent ones of the small back contact type solar cell pieces, a positive electrode contact fine grid end on one of the two opposite sides is electrically isolated from the side, and a negative electrode contact fine grid end on the other of the two opposite sides is electrically isolated from the other side;
each section of the conductive adhesive is distributed between two adjacent ones of the small back contact type solar cell pieces;
each section of the conductive adhesive is connected to the negative electrode contact fine grid of one of the small back contact type solar cell pieces and the positive electrode contact fine grid of the other adjacent one of the small back contact type solar cell pieces.

14. The back contact type solar cell module as to claim 13, **characterized in that**:
the positive electrode contact fine grid end on one of the two opposite sides is covered by an insulating layer, and the negative electrode contact fine grid end on the other of the two opposite sides is covered by an insulating layer;
or,
the positive electrode contact fine grid end on one of the two opposite sides is a shortened end relative to the side, and
the negative electrode contact fine grid end on the other of the two opposite sides is a shortened end relative to the other side.

15. The back contact type solar cell module as to claim 13 or 14, **characterized in that**:
the conductive adhesive has an elongated structure;
the positive electrode contact fine grid end on one of the two opposite sides is connected to one long side of the elongated structure;
the negative electrode contact fine grid end on the other of the two opposite sides is connected to the other long side of the elongated structure.

16. The back contact type solar cell module as to claim 13 or 14, **characterized in that**:
the conductive adhesive includes: an elongated main body and a plurality of branch sections connected to the elongated main body that are separately arranged on both sides of the elongated main body, wherein each branch section on one side of the elongated main body and one positive electrode contact fine grid of one of the adjacent small back contact type solar cell pieces, and each branch section on the other side of the elongated main body and one negative electrode contact fine grid of the other of the adjacent small back contact type solar cell pieces.

17. The back contact type solar cell module as to any of claims 7, 13 and 14, **characterized in that**:
the back contact type solar cell module further comprises: a first encapsulation layer;
the first encapsulation layer is used for filling a gap between the small cell piece and the back plate.

18. The back contact type solar cell module as to claim 17, **characterized by** further comprising: a glass plate and a second encapsulation layer, wherein:
the glass plate is opposite to the plurality of small back contact type solar cell pieces;
the second encapsulation layer is arranged between the glass plate and the plurality of small back contact type solar cell pieces;
the first encapsulation layer and the second encapsulation layer are used for encapsulating the plurality of small back contact type solar cell pieces between the glass plate and the back plate.

19. A method for preparing a back contact type solar cell module as to any of claims 1-12, **characterized by** comprising the following steps:
S1: cutting a small back contact type solar cell piece at equal intervals along the short sides of the n+ doped regions (3) or the p+ doped regions (2) to obtain several small cell pieces;
S2: arranging conductive patterns (72) on a substrate (71) to form a conductive strip (7), and sequentially connecting the respective small cell pieces in series by the conductive strips (7) to form a cell string;
S3: sequentially subjecting the cell string to confluence, stacking and lamination for encapsulation to obtain the back contact type solar cell module.

20. The method for a back contact type solar cell module as to claim 19, **characterized in that**:
in S1, 2≦N≦20.

21. The method for a back contact type solar cell module as to claim 19, **characterized in that**:
in S2, the conductive pattern (72) is dried for solidification on the substrate (71) by printing with a solder or a conductive adhesive, the temperature of drying for solidification is 100-500°C, and the time thereof is 30-600 s.

22. The method of a back contact type solar cell module as to claim 21, **characterized in that**:
the solder is tin, a tin-lead alloy, a tin-bismuth alloy or a tin-lead-silver alloy; the conductive adhesive is an adhesive wrapped with conductive particles, the adhesive is one or more of epoxy resin, phenolic resin, polyurethane, thermoplastic resin or polyimide, and the conductive particles are silver, gold or copper, or alloy particles composed of two or more of silver, gold or copper.

23. A method for preparing a back contact type solar cell module as to any of claims 13-16, **characterized by** comprising:
a step of preparing a back contact type solar cell piece;
printing a conductive adhesive on one surface of a back plate;
arranging a plurality of small back contact type solar cell pieces on the back plate, connecting the plurality of small back contact type solar cell pieces in series by the conductive adhesive, and performing drying for solidification.
